# EUROPEAN PATENT APPLICATION

(11) **EP 1 278 305 A2**
(43) Date of publication of application: **22.01.2003**
(21) Application number: 02250539.0
(22) Date of filing: 28.01.2002
(51) Int. Cl.: H03K 5/24

(54) **High-speed signal transmission**

(30) Priority: 19.07.2001 JP 2001220024; 11.10.2001 JP 2001314159
(71) Applicant: FUJITSU LIMITED, Kawasaki-shi, Kanagawa 211-8588 (JP)
(72) Inventor: Doi, Yoshiyasu, c/o Fujitsu Limited, Kawasaki-shi, Kanagawa 211-8588 (JP); Matsubara, Satoshi, c/o Fujitsu Solution Limited, Kawasaki-shi, Kanagawa 212-0013 (JP); Tamura, Hirotaka, c/o Fujitsu Limited, Kawasaki-shi, Kanagawa 211-8588 (JP)
(74) Representative: Stebbing, Timothy Charles

(57) **Abstract**

A receiver circuit (31-34) has a sampling circuit (411,412), a buffer circuit (420), a determining circuit (430), and a buffer control circuit. The sampling circuit (411,412) samples an input signal, and the buffer circuit (420) buffers an output of the sampling circuit. The determining circuit (430) determines an output of the buffer circuit, and the buffer control circuit keeps a small input signal dependency of the output of the buffer circuit until carrying out the sampling. Consequently, inter symbol interference caused by characteristics of a transmission path which poses a problem for receiving a high-speed signal can be reduced, and therefore the high-speed received signal can be determined with a higher accuracy.

## Description

The present invention relates to a technique for transmitting a signal between a plurality of LSI chips or a plurality of elements or circuit blocks within a single chip, or transmitting a signal between a plurality of boards or a plurality of housings. More particularly, the present invention relates to a receiver circuit used for transmitting a signal at a high speed.

Recently, the performance of components used in computers and other information processing apparatuses has been greatly improved. In particular, dramatic improvements have been made, for example, in the performance of processors and semiconductor memory devices such as SRAMs (Static Random Access Memories) and DRAMS (Dynamic Random Access Memories). The improvements in the performance of semiconductor memory devices, processors, and the like have come to the point where system performance cannot be improved further unless the speed of signal transmission between components or elements is increased.

Specifically, the speed of signal transmission between, for example, a main storage unit such as DRAM and a processor (between LSIs) is hindering the effort for improving the performance of the computer as a whole. Besides, it is becoming necessary to increase the speed of signal transmission not only between the housing and the board (printed wiring board), such as between a server and a main storage unit or between the servers through a network, but also among the chips, among the elements in the chip and among the circuit blocks due to a high degree of integration of the semiconductor chip, an increase in the size thereof, and a decrease in the power source voltage (decrease in the signal amplitude). Realizing a high speed of signal transmission requires a receiver circuit which can remove inter symbol interference (wherein the past signal value adversely affects the determination of a current signal value) and determine data more accurately.

For example, in a conventional receiver circuit, a signal existing before a sample timing is amplified directly by a buffer circuit and input to a determining circuit. As a result, the signal sampled and input to the determining circuit (determining signal) has its voltage considerably varied by the influence of the signal values before the determination timing. The rate at which the voltage value changes at the input node of the determining circuit is limited, and therefore in the conventional receiver circuit, this variation causes inter symbol interference, thereby preventing data from being correctly received (determined).

The prior art and the problems associated with the prior art will be described in detail later with reference to accompanying drawings.

It is therefore desirable to provide a receiver circuit capable of removing inter symbol interference and determine data with higher accuracy.

According to the present invention, there is provided a receiver circuit comprising a sampling circuit sampling an input signal; a buffer circuit buffering an output of the sampling circuit; a determining circuit determining an output of the buffer circuit; and a buffer control circuit keeping a small input signal dependency of the output of the buffer circuit until carrying out the sampling.

Further, according to the present invention, there is provided a receiver circuit comprising a sampling circuit sampling an input signal; a buffer circuit buffering an output of the sampling circuit; a determining circuit determining an output of the buffer circuit; and a buffer control circuit keeping a substantially constant value of the output of the buffer circuit until carrying out the sampling.

In addition, according to the present invention, there is provided a receiver circuit device comprising a plurality of receiver units operating in interleaved fashion, wherein each receiver unit comprises a sampling circuit sampling an input signal; a buffer circuit buffering an output of the sampling circuit; a determining circuit determining an output of the buffer circuit; and a buffer control circuit keeping a small input signal dependency of the output of the buffer circuit until carrying out the sampling.

According to the present invention, there is also provided a signal transmission system comprising a driver circuit, a signal transmission portion and a receiver circuit receiving an output of the driver circuit sent through the-signal transmission portion, wherein the receiver circuit comprises a sampling circuit sampling an input signal; a buffer circuit buffering an output of the sampling circuit; a determining circuit determining an output of the buffer circuit; and a buffer control circuit keeping a small input signal dependency of the output of the buffer circuit until carrying out the sampling.

Further, according to the present invention, there is provided a signal transmission system comprising a driver circuit, a signal transmission portion and a receiver circuit receiving an output of the driver circuit sent through the signal transmission portion, wherein the receiver circuit comprises a sampling circuit sampling an input signal; a buffer circuit buffering an output of the sampling circuit; a determining circuit determining an output of the buffer circuit; and a buffer control circuit keeping a substantially constant value of the output of the buffer circuit until carrying out the sampling.

In addition, according to the present invention, there is provided a receiver circuit device comprising a plurality of receiver units operating in interleaved fashion, wherein each receiver unit comprises a sampling circuit sampling an input signal; a buffer circuit buffering an output of the sampling circuit; a determining circuit determining an output of the buffer circuit; and a buffer control circuit keeping a substantially constant value of the output of the buffer circuit until carrying out the sampling.

The buffer control circuit may be a switch arranged between the buffer circuit and a power line. The buffer control circuit may be a switch arranged between the output of the buffer circuit and a load device. The receiver circuit (unit) may further comprise a precharge circuit precharging an input of the determining circuit before the sampling circuit samples the input signal. The sampling circuit may comprise a plurality of sample switches sampling a series of bits, and a plurality of the buffer circuits corresponding to the sample switches may be provided.

The buffer circuit may comprise a plurality of buffer circuit units, and characteristics of a signal transmission path may be compensated by adjusting a magnitude of an output of the buffer circuit units. The buffer circuit may be a transconductor converting an input voltage to a current, and the buffer control circuit may be a current source switch which keeps a small current of the transconductor until carrying out the sampling. The buffer circuit may comprise a micro current circuit for keeping a micro current flowing in the buffer circuit before the sampling circuit samples the input signal. The receiver circuit (unit) may further comprise a switching circuit, ensuring a substantially constant output of the buffer circuit when the sampling circuit samples the input signal, provided at the output of the buffer circuit.

According to the present invention, there is provided a receiver circuit comprising a sampling circuit sampling an input signal; a determining circuit determining an output of the sampling circuit; and a sampling control circuit dynamically changing a transconductance from the input to the output of the sampling circuit and sufficiently reducing the input signal dependency of the output of the sampling circuit at other than a sampling time point.

Further, according to the present invention, there is provided a signal transmission system comprising a driver circuit, a signal transmission portion and a receiver circuit receiving an output of the driver circuit sent through the signal transmission portion, wherein the receiver circuit comprises a sampling circuit sampling an input signal; a determining circuit determining an output of the sampling circuit; and a sampling control circuit dynamically changing a transconductance from the input to the output of the sampling circuit and sufficiently reducing the input signal dependency of the output of the sampling circuit at other than a sampling time point.

In addition, according to the present invention, there is provided a receiver circuit device comprising a plurality of receiver units operating in interleaved fashion, wherein each receiver unit comprises a sampling circuit sampling an input signal; a determining circuit determining an output of the sampling circuit; and a sampling control circuit dynamically changing a transconductance from the input to the output of the sampling circuit and sufficiently reducing the input signal dependency of the output of the sampling circuit at other than a sampling time point.

The sampling control circuit may change by switching the transconductance from the input to the output of the sampling circuit. The transconductance may be switched by switching a tail current of a differential transistor pair. The tail current may be switched by switching a current path between a route of the tail current of the transconductor and the other routes.

The current may be switched by a transistor switch for switching the drain current of the differential transistor pair. The current may be switched by injecting to a source of the input transistor of the transconductor a current in such a direction as to turn off the input transistor. The current may be switched by use of a transistor connected in parallel such that the period during which the tail current flows is determined by the superposed portion of multi-phase clock signals.

The current may be switched by use of a transistor connected in series such that the period during which the tail current flows is determined by the superposed portion of multi-phase clock signals. A plurality of the sampling circuits may sample different bit cells for a single determining circuit, and a weighted sum of the outputs of a plurality of the sampling circuits may be determined.

The present invention will be more clearly understood from the description of the preferred embodiments as set forth below with reference to the accompanying drawings, wherein:
Fig. 1 is a block diagram schematically showing a general configuration of a signal transmission system;
Fig. 2 is a block diagram showing a configurational example of the receiver circuit in Fig. 1;
Fig. 3 is a block diagram showing an example circuit of a receiver unit of the conventional receiver circuit;
Figs. 4A, 4B and 4C are diagrams for explaining the problems of the conventional receiver circuit;
Fig. 5 is a block diagram showing an example circuit having a basic configuration of a receiver circuit according to a first aspect of the invention;
Figs. 6A, 6B and 6C are diagrams for explaining the operation of the receiver circuit shown in Fig. 5;
Fig. 7 is a block diagram showing a receiver circuit according to a first embodiment of the invention;
Fig. 8 is a block diagram showing a receiver circuit according to a second embodiment of the invention;
Fig. 9 is a block diagram showing a receiver circuit according to a third embodiment of the invention;
Fig. 10 is a circuit diagram showing an example of an equalizer circuit of the receiver circuit of Fig. 9;
Fig. 11 is a circuit diagram showing an example of a determining circuit of the receiver circuit of Fig. 9;
Fig. 12 is a timing chart for explaining the operation of the receiver circuit shown in Fig. 9;
Fig. 13 is a block diagram showing a receiver circuit according to a fourth embodiment of the invention;
Fig. 14 is a diagram for explaining the operation of the receiver circuit shown in Fig. 13;
Fig. 15 is a timing chart for explaining the operation of the receiver circuit shown in Fig. 13;
Fig. 16 is a block diagram showing an example of the basic configuration of a receiver circuit according to a second aspect of the invention;
Fig. 17 is a diagram for explaining the operation of the receiver circuit shown in Fig. 16;
Fig. 18 is a circuit diagram showing a receiver circuit according to a fifth embodiment of the invention;
Fig. 19 is a diagram showing an example of a circuit for generating an analog source voltage in the receiver circuit shown in Fig. 18;
Fig. 20 is a circuit diagram showing a receiver circuit according to a sixth embodiment of the invention;
Fig. 21 is a circuit diagram showing a receiver circuit according to a seventh embodiment of the invention;
Fig. 22 is a circuit diagram showing a receiver circuit according to an eighth embodiment of the invention;
Fig. 23 is a circuit diagram showing a receiver circuit according to a ninth embodiment of the invention;
Fig. 24 is a circuit diagram showing a modification of the receiver circuit of Fig. 23;
Fig. 25 is a circuit diagram showing a receiver circuit according to a tenth embodiment of the invention;
Fig. 26 is a circuit diagram showing a receiver circuit according to an 11th embodiment of the invention;
Fig. 27 is a block diagram showing a receiver circuit according to a 12th embodiment of the invention;
Fig. 28 is a timing chart for explaining the operation of the receiver circuit shown in Fig. 27;
Fig. 29 is a block diagram showing a receiver circuit according to a 13th embodiment of the invention;
Fig. 30 is a timing chart for explaining the operation of the receiver circuit shown in Fig. 29;
Fig. 31 is a circuit diagram showing a receiver circuit according to a 14th embodiment of the invention; and Fig. 32 is a timing chart for explaining the operation of the receiver circuit shown in Fig. 31.

Prior to explanation of embodiments of the invention, a conventional receiver circuit and the problem points thereof will be described with reference to the accompanying drawings.

In recent years, demand is high for increasing the signal transmission rate per pin in order to meet the increased data transmission volume between LSIs, boards or housings. It is thus possible to avoid the increase also in the cost of the package, etc. which otherwise might be caused by an increased number of pins. As a result, the signal transmission rate between LSIs is expected to increase to more than 1 Gbps and in the future (in three to eight years), to a still higher value (high signal transmission rate) of 4 Gbps or 10 Gbps.

This high signal frequency is higher than the internal signals of the LSI, for example, and therefore requires a receiver circuit capable of high-speed operation. Generally, the receiver circuit is configured of a switch and a buffer circuit arranged in series on an input line, and the value of the signal at the timing of turning off the switch is sampled and constitutes an output of the buffer circuit. By latching the output of the buffer circuit, the signal value is determined.

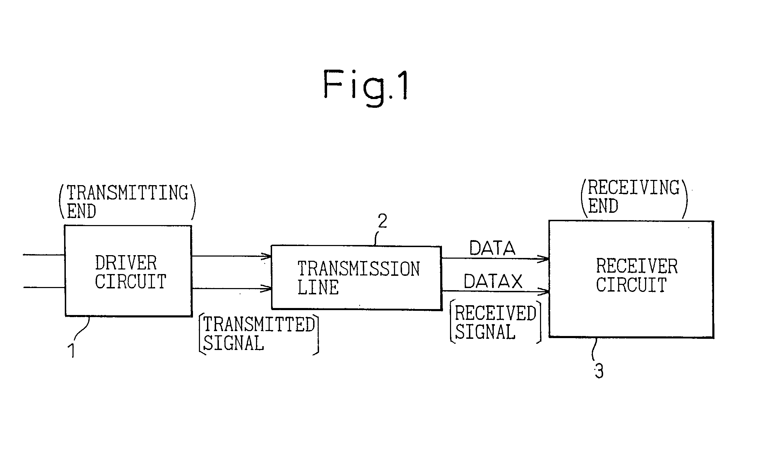

Fig. 1 is a block diagram schematically showing a general configuration of a signal transmission system. In Fig. 1, reference numeral 1 designates a driver circuit (transmitting circuit), numeral 2 a transmission line (signal transmission path), and numeral 3 a receiver circuit (receiving circuit). The driver circuit 1 at the transmitting end and the receiver circuit 3 at the receiving end are arranged in different LSIs or housings, respectively, but may alternatively be arranged in different circuit blocks of a single LSI.

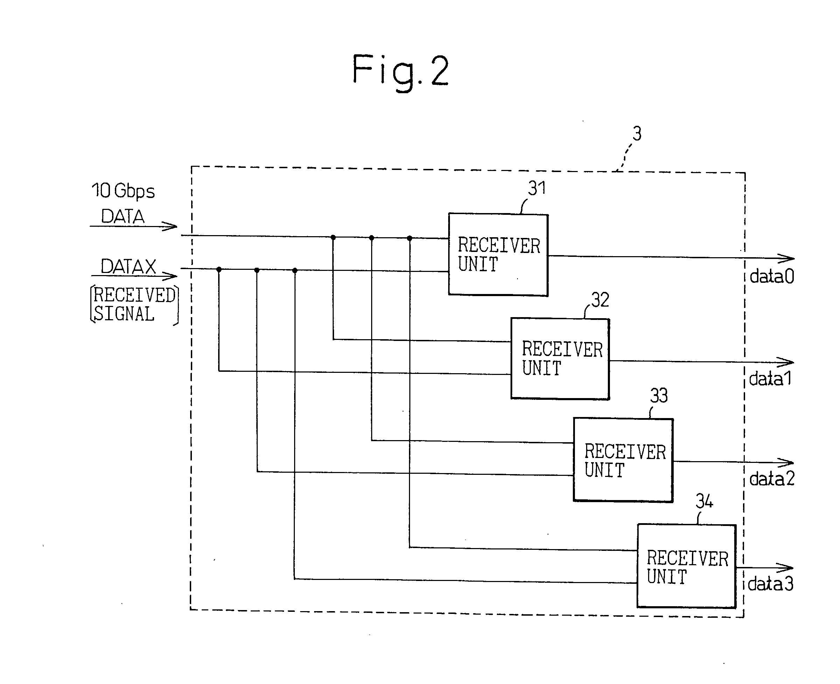

Fig. 2 is a block diagram showing an example of the receiver circuit 3 shown in Fig. 1.

As shown in Fig. 2, the receiver circuit 3 is so configured that the high-speed data (complementary data, differential data) DATA, DATAX of 10 Gbps sent from the driver circuit 1 through the transmission line 2, for example, are received (determined) by four receiver units 31 to 34 operating in accordance with a clock signal of 2.5 GHz by interleaving. Specifically, the input data DATA, DATAX of 10 Gbps are received as 4-bit, 2.5-Gbps data by the four receiver units 31 to 34 operating in four shifts.

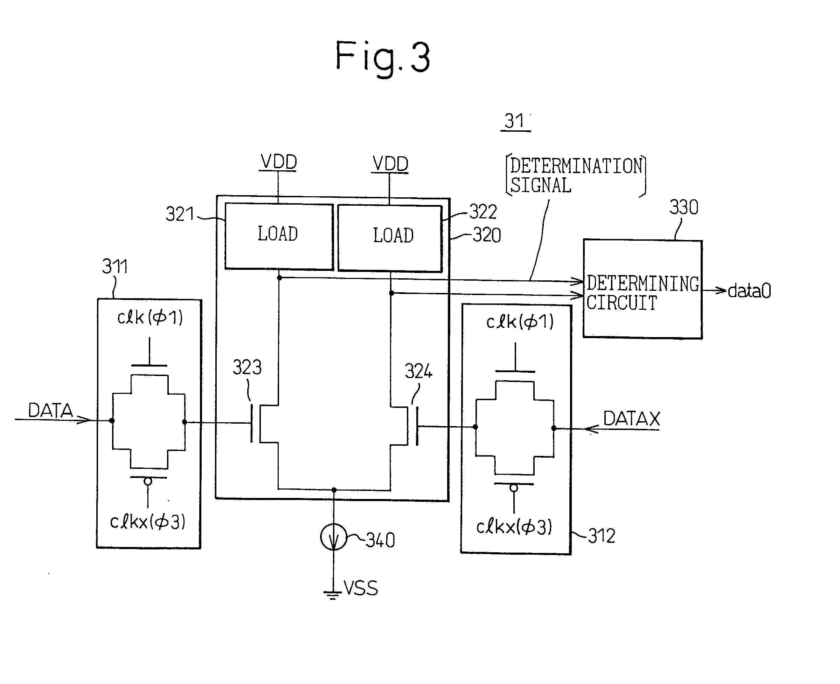

Fig. 3 is a block diagram showing a circuit example the receiver unit of the conventional receiver circuit, which is an example of the conventional configuration of the receiver unit 31 in the receiver circuit 3 shown in Fig. 2.

As shown in Fig. 3, the receiver unit 31 (like the receiver units 32 to 34) includes sample switches 311, 312, a buffer circuit 320, a determining circuit 330 and a current source 340. The sample switches 311, 312 are each configured as a transfer gate controlled by clock signals clk (φ1), clkx (φ3). The input signals (DATA, DATAX) are retrieved by the buffer circuit 320 at the rise timing of the clock signal clk of 2.5 GHz (the fall timing of the clock clkx), for example. The clock signal φ3 is one of the four-phase clock signals φ0 to φ3, in which the relation holds that φ3 = /φ1. The signal /φ1 is complementary to (has an inverted level of) the signal φ1.

The buffer circuit 320 is configured as a differential amplifier having loads 321, 322 and n-channel MOS transistors (nMOS transistors) 323, 324 for differential input. The sources of the transistors 323, 324 are connected to a common point on the one hand and connected to a power line VSS of low potential through the current source 340 on the other. Further, the outputs of the buffer circuit 320 are retrieved from the connection nodes between the transistors 323, 324 and the loads 321, 322, respectively, and supplied to the determining circuit 330. Also, the other terminals of the loads 321, 322 are connected respectively to corresponding power lines VDD of high potential. The determining circuit 330 determines by comparison the differential outputs of the buffer circuit 320 and outputs data data0.

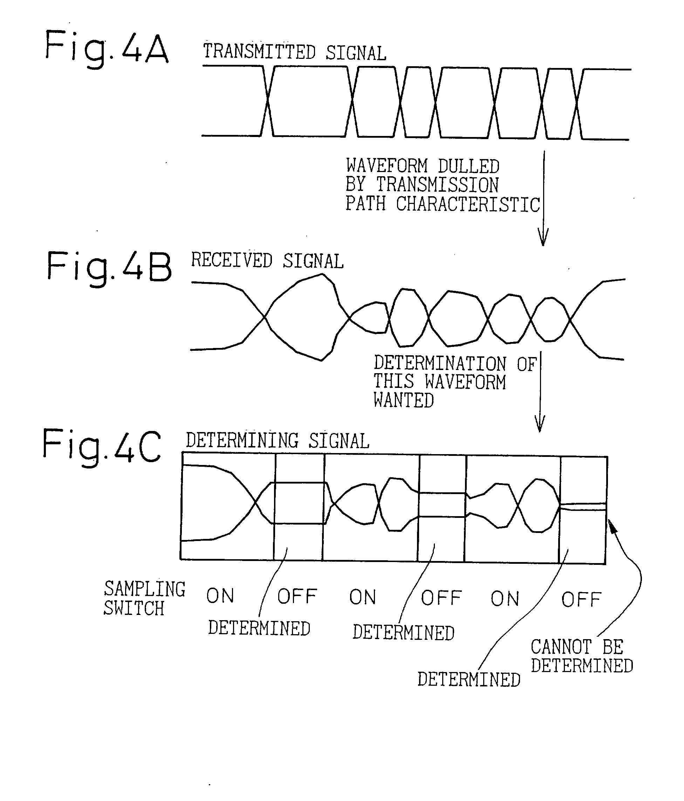

Figs. 4A, 4B and 4C are diagrams for explaining the problems of the conventional receiver circuit. Fig. 4A shows a waveform of the transmitted signal, Fig. 4B a waveform of the received signal, and Fig. 4C a waveform of the determining signal.

Comparison of Figs. 4A and 4B apparently shows that the transmitted signal output from the driver circuit 1 at the transmitting end is supplied as received (input) signals (DATA, DATAX) to the receiver circuit 3 at the receiving end through the transmission line 2. These received signals have a waveform considerably dulled by the transmission path characteristics, etc. of the transmission line 2.

The received signals having a dulled waveform are received and determined by the receiver unit 31 (receiver circuit 3) described above. Specifically, the sample switches 311, 312 are turned on so that the received signals (DATA, DATAX) are retrieved by the buffer circuit 320, the output of which is determined by the determining circuit 330.

In this conventional receiver circuit, the signal values before the sample timing (the received signals before the sample switches 311, 312 are turned on) are amplified directly by the buffer circuit 320 and input to the determining circuit 330. As a result, the input signals (determining signals) to the determining circuit 330 have the voltage thereof considerably varied in accordance with the signal values before the determination timing. The rate at which the voltage value changes at the input node of the determining circuit is limited, and therefore in the conventional receiver circuit 3, the variation causes inter symbol interference (the past signal value adversely affects the determining circuit), thereby preventing data from being correctly received (determined).

Now, a basic configuration of a receiver circuit according to this invention will be explained.

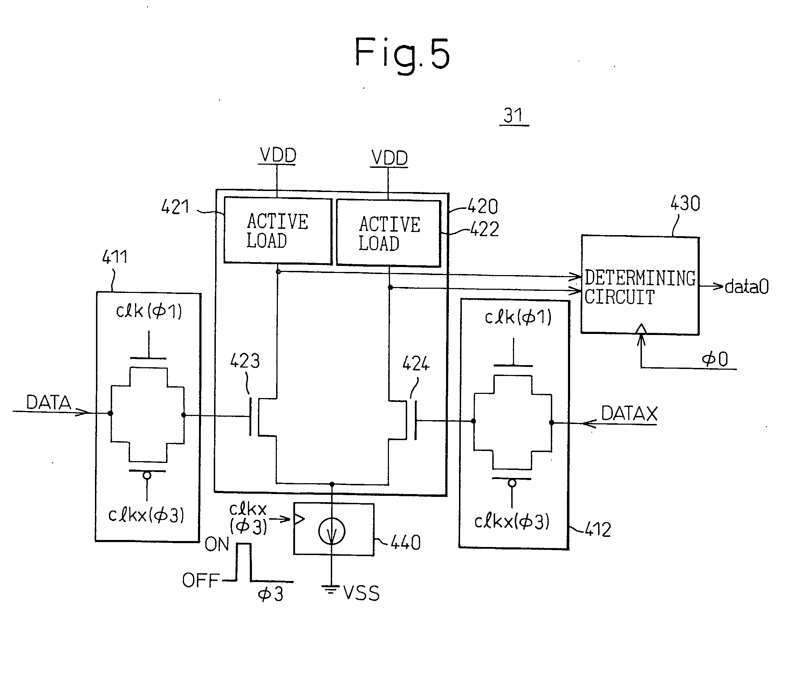

Fig. 5 is a block diagram showing an example of a basic configuration of a receiver circuit according to a first aspect of the present invention. This represents a configuration example of the above-mentioned receiver unit of the receiver circuit shown in Fig. 2.

As shown in Fig. 5, the receiver unit 31 (like the receiver units 32 to 34) is configured of sample switches 411, 412, a buffer circuit 420, a determining circuit 430 and a current source 440. The sample switches 411, 412 are configured as transfer gates controlled by clock signals clk (φ1), clkx (φ3), respectively. The input signals (DATA, DATAX) are retrieved by the buffer circuit 420, for example, at the rise timing of a 2.5-GHz clock signal clk (the fall timing of a clock signal clkx), for example. The signal DATAX represents a signal complementary to (having an inverted level of) the signal data DATA, and the clock signal φ3, which is one of the four-phase clock signals φ0 to φ3, is given as φ3 = /φ1. Incidentally, the signal /φ1 indicates a signal complementary to the signal φ1. The receiver circuit according to the first aspect of the invention is not limited to the configuration having the four receiver units (31), but may alternatively be configured of a plurality of, say, two or eight receiver units.

The buffer circuit 420 is configured as a differential amplifier including active loads 421, 422 and nMOS transistors 423, 424 for differential input. The sources of the transistors 423, 424 are connected to a common point on the one hand and connected to a power line VSS of low potential through a current source 440 on the other. Further, the outputs of the buffer circuit 420 are retrieved from the connection nodes between the transistors 423, 424 and the loads 421, 422, respectively, and supplied to a determining circuit 430, while the other terminals of the loads 421, 422 are connected to power lines VDD, respectively, of high potential.

The current source 440 is controlled by being switched in accordance with the clock signal clkx (φ3) (switched on by high level "H" of the clock signal φ3). The determining operation of the determining circuit 430, on the other hand, is controlled by the clock signal φ0 (determined by the high level "H" of the clock signal φ1). The clock signal φ0 is one of the four-phase signals φ0 to φ3, and 90° out of phase with the clock signal φ3 (clkx). The determining circuit 430 determines the data by comparing the differential outputs of the buffer circuit 420 in accordance with the clock signal φ0 and outputs the data data0.

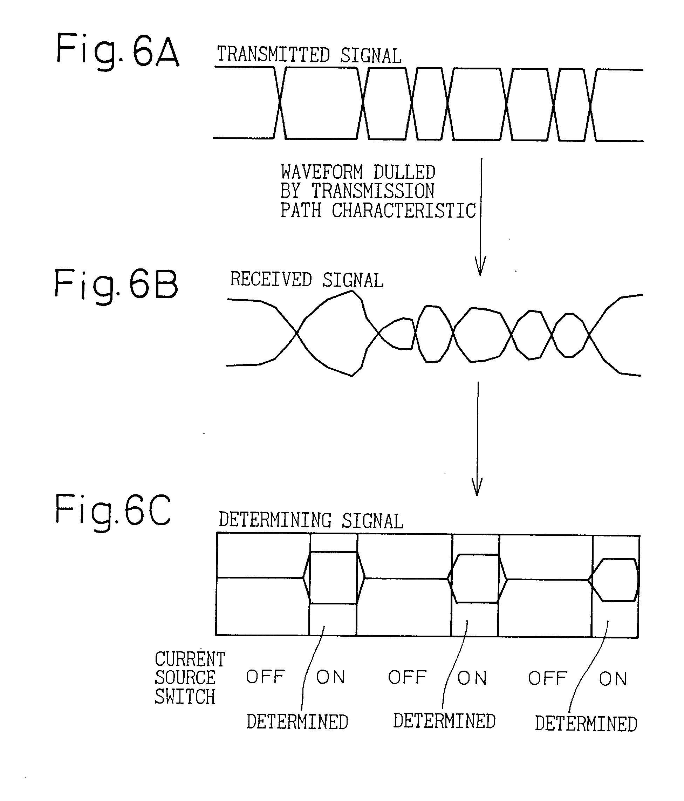

Figs. 6A, 6B and 6C are diagrams for explaining the operation of the receiver circuit shown in Fig. 5. Fig. 6A shows a waveform of the transmitted signal, Fig. 6B a waveform of the received signal, and Fig. 6C a waveform of the determining signal. The waveforms of the transmitted and received signals shown in Figs. 6A and 6B, respectively, are similar to the aforementioned corresponding waveforms shown in Figs. 4A and 4B.

Comparison between Figs. 6C and 4C clearly shows that the receiver circuit according to this invention, as shown in Fig. 5, for example, is such that the sample switches 411, 412 are controlled by the clock signal φ1 (φ3), while the current source 440 is controlled by being switched by the clock signal φ3, and further the operation of the determining circuit 430 is controlled by the clock signal φ0. Therefore, the inter symbol interference due to the previous signals is removed and accurate data determination is made possible.

Specifically, the receiver circuit according to the invention, as shown in Fig. 5, is such that a buffer circuit 420 is inserted in the stage following the sampling switches (sampling circuits) 411, 412, and in order to control the timing of the drive of the buffer circuit 420 and the load devices (active loads) 421, 422, the current source (current source switch) 440 controlled by switching in accordance with the clock signal φ3 is arranged.

First, the current source switch 440 is turned off and the buffer circuit 420 is not activated (driven) while the sampling switches 411, 412 are on (when the clock signal φ1 is at high level "H" and the clock signal φ3 is at low level "L"). Therefore, the output of the buffer circuit 420 is not dependent on the input signals DATA, DATAX. During this period, therefore, the output value of the buffer circuit 420 is kept constant. Specifically, the outputs (differential outputs) of the buffer circuit 420 both assume the source voltage VDD of high potential through the active loads 421, 422, respectively, and the level of the source voltage VDD is applied as a differential input to the determining circuit 430.

Then, when the switches of the sampling circuits 411, 412 turn off (when the clock signal φ1 turns from high level "H" to low level "L", and the clock signal φ3 turns from low level "L" to high level "H"), the current source switch 440 turns on so that the buffer circuit 420 is activated and outputs a valid signal. The determining circuit 430 in the stage subsequent to the buffer circuit 420 determines the signal only during the timing when the buffer circuit 420 outputs a signal in accordance with the clock signal φ0 (the clock signal 90° out of phase with the clock signal φ3).

Specifically, the output of the buffer circuit 420 assumes a constant voltage (VDD) during other than the determination timing when the determining circuit 430 operates, and therefore the inter symbol interference caused by the transmission path characteristics for receiving a high-speed signal can be removed.

In this way, with the receiver circuit according to this invention, the received signal before the determination timing is not input to the determining circuit, and therefore the inter symbol interference of a series of the received signals caused by the transmission line characteristics can be prevented, thereby making it possible for the signal determining circuit to make determination with high accuracy.

Embodiments of the receiver circuit according to this invention will be described in detail below with reference to the accompanying drawings.

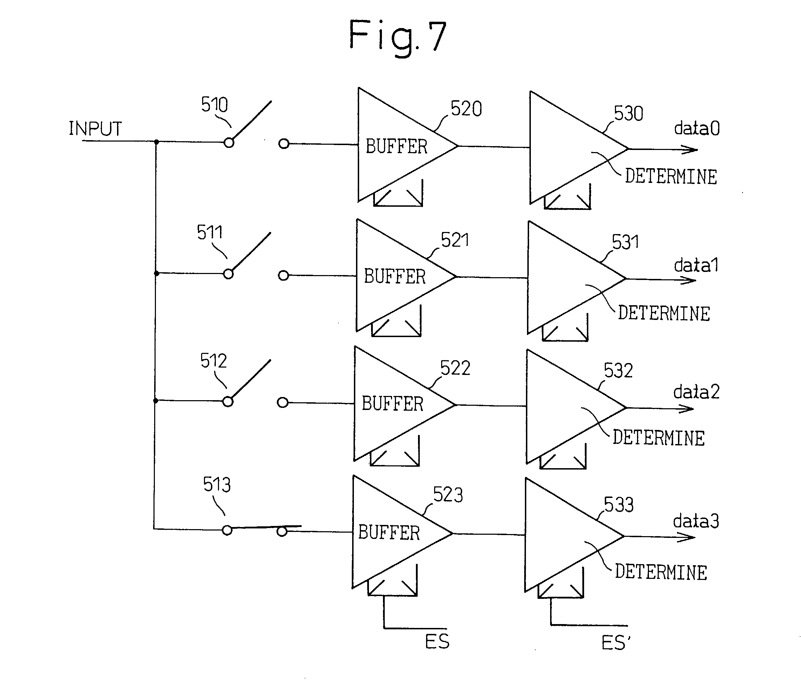

Fig. 7 is a block diagram showing a receiver circuit according to a first embodiment of the invention. Four sets of the receivers shown in Fig. 5 are provided for performing the interleave operation. In Fig. 7, reference numerals 510 to 513 designate sample switches (sampling circuit units), numerals 520 to 523 buffer circuits (buffer circuit units) and numerals 530 to 533 determining circuits (determining circuit units).

The receiver circuits (receiver circuit devices) according to the first embodiment shown in Fig. 7 are each for receiving a high-speed signal of 10 Gbps, for example, and is configured as a circuit for performing the four-way interleave operation in accordance with the four-phase clock signals of 2.5 GHz. The receiver circuit according to this first embodiment includes sample switches 510 to 513, buffer circuits 520 to 523, current source switches and determining circuits 530 to 533. The current source switch is built into each of the buffer circuits 520 to 523.

The received signal INPUT is input through the sample switches 510 to 513 (sampling units), and controlled, for example, by the four-phase clock signals φ0 to φ3 which are 90° out of phase with each other. As a specific example, the sample switch 511 is adapted to turn off at the fall of the clock signal φ1, and the current source switch turns on at the rise of the clock signal φ3 (the inverted signal ES of the clock signal φ1), thus setting the buffer circuit 521 in drive mode. The buffer circuit 521 thus amplifies the voltage value prevailing at the particular time point and outputs it to the determining circuit 531. The determining circuit 531 determines the signal from the buffer circuit 521 at the rise of the clock signal φ0 (signal ES'), and outputs it as a value of data of "0" or "1".

As another example, the sample switch 512 turns off at the fall of the clock signal φ2, and the current source switch turns on at the rise of the clock signal φ0 (the inverted signal ES' of the clock signal φ2). Thus, the buffer circuit 522 is set in drive mode. The buffer circuit 522 amplifies the voltage value as of that time point and outputs it to the determining circuit 532. The determining circuit 532 determines the signal from the buffer circuit 522 at the rise of the clock signal φ1 (signal ES'), and outputs it as data of "0" or "1" value.

As described above, the receiver circuit according to the first embodiment, upon turning off the current source switch for controlling the drive of the buffer circuits 520 to 523 by the clock signals φ0 to φ3, holds the outputs of the buffer circuits 520 to 523 at a constant value. In this way, the received signal INPUT is prevented from being input to a determining circuit before the determination timing of the determining circuits 530 to 533, thereby making possible a highly accurate determination free of inter-signal interference.

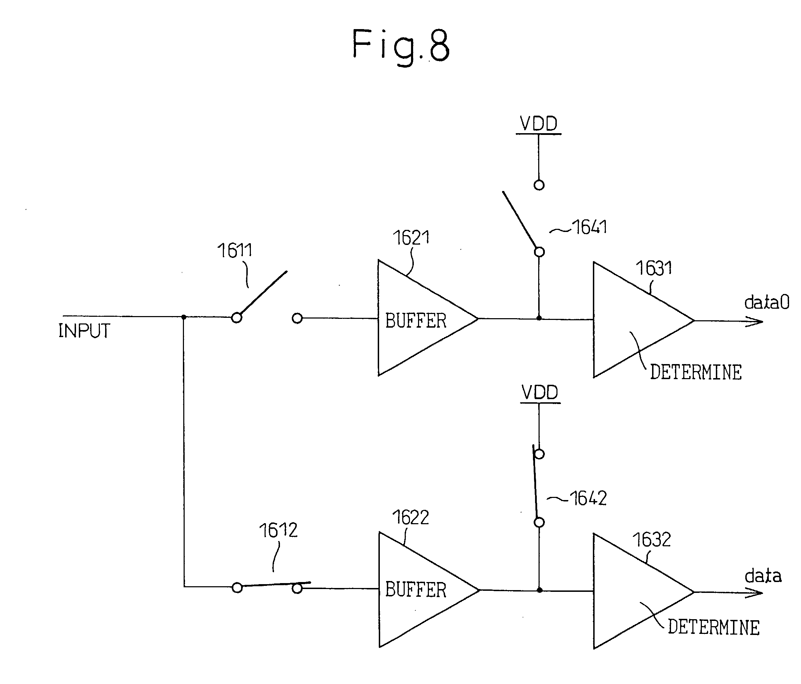

Fig. 8 is a block diagram showing a receiver circuit according to a second embodiment of the invention. In Fig. 8, reference numerals 1611, 1612 designate sample switches, numerals 1621, 1622 buffer circuits, numerals 1631, 1632 determining circuits, and numerals 1641, 1642 switch circuits (pMOS switches).

The receiver circuit according to the second embodiment shown in Fig. 8 has the switch circuits 1641, 1642 arranged at the connection nodes, respectively, between the buffer circuits 1621, 1622 and the determining circuits 1631, 1632. When the sample switch 1611 is turned off while the other sample switch 1612 is turned on, for example, the switch circuit 1641 also is turned off while the other switch circuit 1642 is turned on.

Specifically, as long as the sample switch 1612 is in the on state, the switch circuit 1642 in parallel to the load element connected to the output of the buffer circuit 1622 is turned on (turned to low resistance), and during this period, the output of the buffer circuit 1622 assumes a substantially constant value. In the process, the sample switch 1611 is in the off state and the switch circuit 1641 is also turned off.

Once the sample switch 1612 turns off, the switch circuit 1642 also turns off, so that the sampled output of the buffer circuit 1622 is input to the determining circuit 1632, and the inter-signal interference can be prevented. At this time, the sample switch 1611 and the switch circuit 1641 turn on, and during this period, the output of the buffer circuit 1621 assumes a substantially constant value.

According to this second embodiment, the output current of the buffer circuit is allowed to flow during any period, thereby leading to the advantage that the bias conditions for the drive transistor of the buffer circuit are reduced and the high-speed operation is made possible.

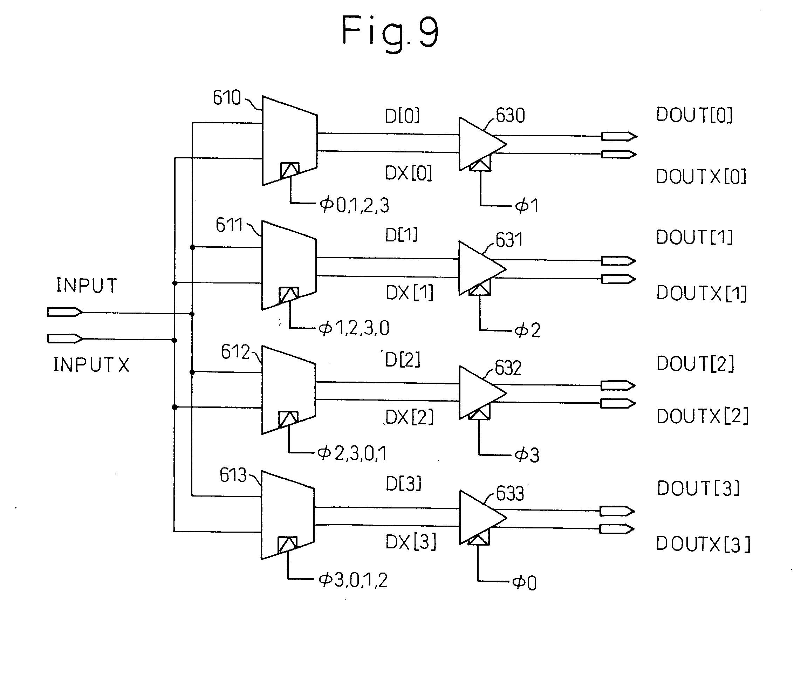

Fig. 9 is a block diagram showing a receiver circuit according to a third embodiment of the invention. This embodiment is equivalent to the first embodiment of Fig. 7, but it is so configured that the input signal INPUT is replaced with differential signals (complementary signals) INPUT, INPUTX, the determining circuits 530 to 533 are replaced with differential determining circuits 630 to 633, and the sample switches 510 to 513 and the buffer circuits 520 to 523 are replaced with equalizer circuits (transconductors) 610 to 613, respectively. The equalizer circuits 610 to 613 are controlled by the four-phase clock signals φ0 to φ3 which are 90° out of phase with each other, and the determining circuits 630, 631, 632, 633 perform the determining operation in accordance with the clock signals φ1, φ2, φ3, φ0, respectively.

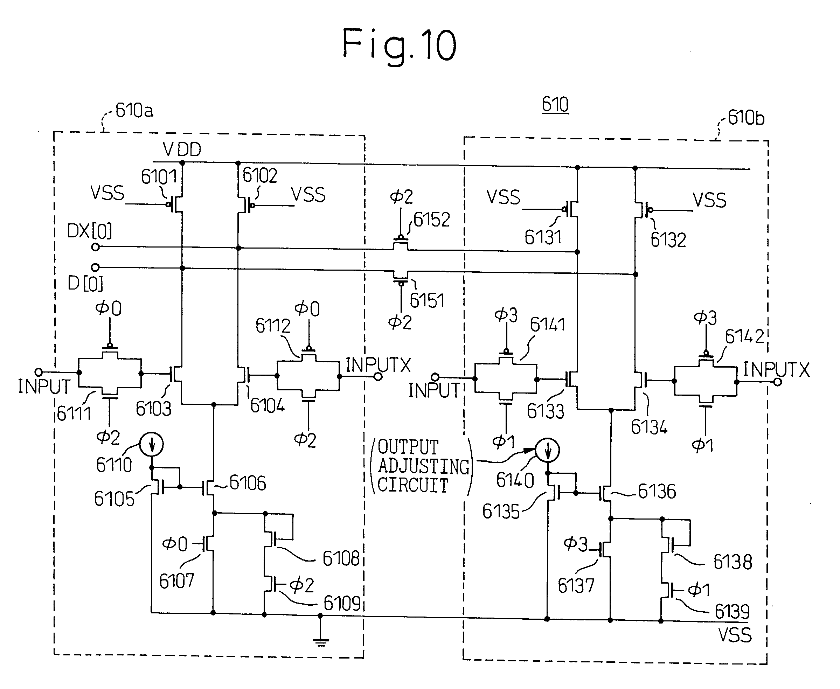

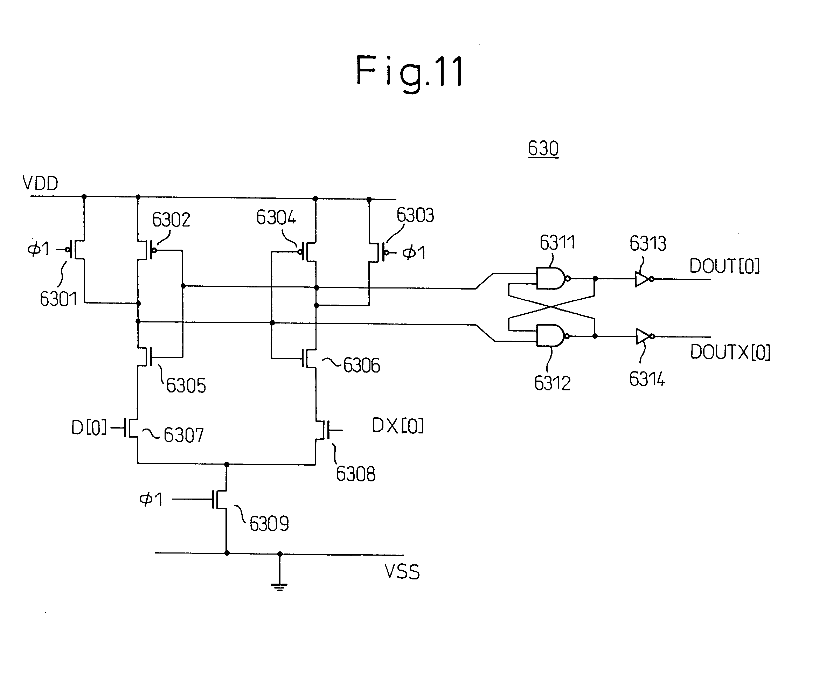

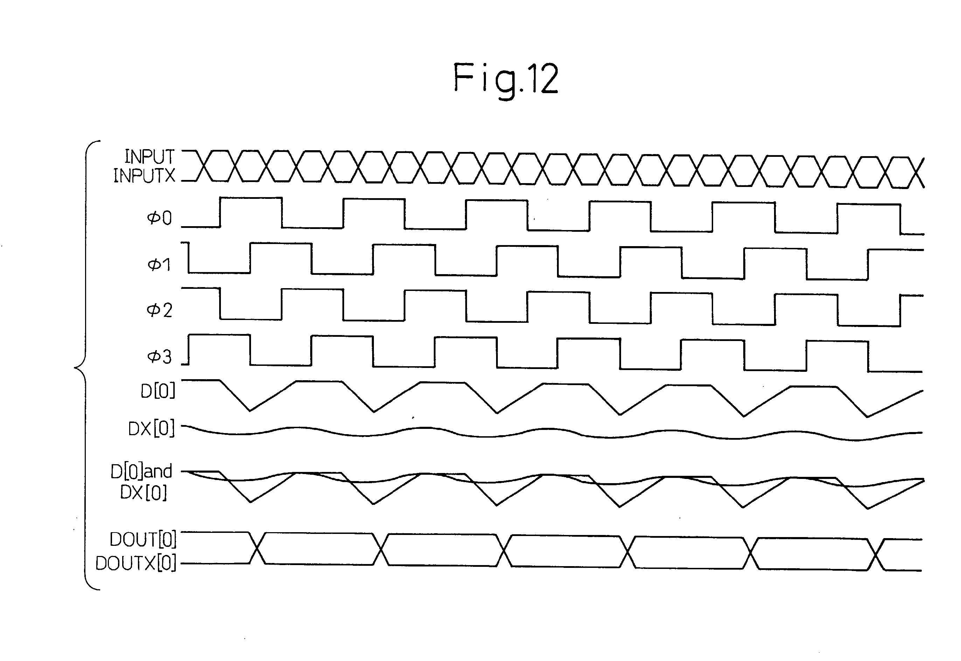

Fig. 10 is a circuit diagram showing an example of the equalizer circuit in the receiver circuit shown in Fig. 9. Fig. 11 is a circuit diagram showing an example of the determining circuit in the receiver circuit shown in Fig. 9. Fig. 12 is a timing chart for explaining the operation of the receiver circuit of Fig. 9. The clock signals φ0 to φ3, as shown in Fig. 12, are the four-phase clock signals 90° out of phase with each other.

As shown in Fig. 10, the equalizer circuit 610 includes pMOS transistors 6101, 6102; 6131, 6132; 6151, 6152, nMOS transistors 6103 to 6109; 6133 to 6139, current sources 6110; 6140 and transfer gates 6111, 6112; 6141, 6142. The equalizer circuits 611 to 613 are also configured similarly to the equalizer circuit 610. Specifically, the equalizer circuit 610 includes two differential amplifiers (transconductors) 610a, 610b. According to this embodiment, the output level is adjusted by the two differential amplifiers 610a, 610b thereby to compensate for the signal transmission characteristics (to reduce the inter symbol interference). Specifically, in the prior art, the inter symbol interference is reduced by holding data of the signal transmitted previously through a combination of a switch and a capacitor. According to this embodiment, in contrast, the inter symbol interference is reduced by using the two differential amplifiers 610a, 610b, for example. By the way, the output level of the differential amplifier 610b can be adjusted by controlling the current flowing in the current source 6140. Also, it is possible to adjust the output level of the differential amplifier 610a by controlling the current flowing in the current source 6110. Normally, however, it is sufficient to adjust the output level of the differential amplifier 610b by controlling the current flowing in the current source 6140.

The differential amplifier 610a includes sample switches 6111, 6112 configured of transfer gates controlled by the clock signals φ0, φ2, active loads (transistors) 6101, 6102 whose gates have applied to them the low-potential source voltage VSS, differential input transistors 6103, 6104, a current source 6110 and a switch 6107. The sample switches 6111, 6112 turn on when the clock signal φ2 is at high level "H" (when the clock signal φ0 is at low level "L"), and the transistor 6107 controlled by the clock signal φ0 which turns to high level "H" at the timing of the fall of the clock signal φ2 from high level "H" to low level "L" is turned on, so that the buffer circuits (transistors 6101 to 6104) are activated thereby to retrieve the input signals INPUT, INPUTX.

The transistor 6105 is connected in current mirror fashion with the transistor 6106, and the current (about 10 µA, for example) in the buffer circuits (transistors 6101 to 6104) flows through this transistor 6106. The transistor (micro current circuit) 6109 controlled by the clock signal φ2 is turned on when the clock φ0 is at low level "L" and the switch (transistor) 6107 is off, so that a micro current (about 1 µA, for example) flows to the transistor 6106 through the transistor 6108. Thus, the kickback noise generated by the differential input transistors 6103, 6104 is reduced.

In similar fashion, the other differential amplifier 610b includes sample switches 6141, 6142 configured by transfer gates controlled by the clock signals φ3, φ1, active loads (transistors) 6131, 6132 whose gates have applied to them the low-potential source voltage VSS, differential input transistors 6133, 6134, a current source 6140 and a switch 6137. The sample switches 6141, 6142 turn on when the clock signal φ1 is at high level "H" (when the clock signal φ3 is at low level "L"), and the transistor 6137 controlled by the clock signal φ3 which turns to high level "H" at the timing of the fall of the clock signal φ1 from high level "H" to low level "L" is turned on, so that the buffer circuits (transistors 6131 to 6134) are activated thereby to retrieve the input signals INPUT, INPUTX.

The transistor 6135 is connected in current mirror fashion with the transistor 6136, and the current in the buffer circuits (transistors 6131 to 6134) flows through this transistor 6136. The transistor (micro current circuit) 6139 controlled by the clock signal φ1 is turned on when the clock signal φ3 is at low level "L" and the transistor 6137 is in off state, so that a micro current flows to the transistor 6136 through the transistor 6138. Thus, the kickback noise generated by the differential input transistors 6133, 6134 is reduced. Also, by controlling the current flowing in the current source 6140, the output level of the differential amplifier 610b can be adjusted.

The pMOS transistors 6151, 6152 are controlled by the clock signal φ2, and turn on at the fall of the clock signal φ2 to low level "L", so that the outputs of the two differential amplifiers 610a, 610b are connected thereby to supply the differential outputs D[0] and DX[0] to the determining circuit 630.

As described above, the equalizer circuit (610) has two differential amplifiers 610a, 610b, each of which amplifies the series of the received signals at a different timing (clock signals φ0, φ2; φ3, φ1). Further, at the rise of the clock signal φ2, for example, the outputs are applied at the same time to a single determining circuit (630). By adjusting the magnitude of the output (weighting the output) with the two differential amplifiers (transconductors) 610a, 610b, the inter-signal interference caused by the characteristics of the transmission path is compensated to further improve the accuracy of determination by the determining circuit.

As shown in Fig. 11, the determining circuit 630 is controlled by the clock signal φ1. The other determining circuits 631, 632, 633 are also configured similarly to the determining circuit 630 and controlled by the clock signals φ2, φ3, φ0, respectively, for interleave operation.

The determining circuit 630 includes pMOS transistors 6301 to 6304, nMOS transistors 6305 to 6309, NAND gates 6311, 6312 and inverters 6313, 6314. The gate of the transistor 6301 is supplied with the clock signal φ1, so that when the clock signal φ1 is at high level "H", the circuit (differential circuit) is activated to perform the determining operation. Further, the clock signal φ1 is supplied also to the gates of the transistors 6301, 6303, 6309, so that when the clock signal φ1 is at low level "L" with the differential circuit inactive, the precharge transistors 6301, 6303 are turned on, thereby precharging the input level of the latch due to the NAND gates 6311, 6312. By the way, the inverters 6313, 6314 are for shaping the output waveform of the latch (NAND gates 6311, 6312), and the result of determination (differential output signals DOUT[0], DOUTX[0]) is output through the inverters 6311, 6312.

The determining circuits 630, 631, 632, 633 are controlled by the clock signals φ1, φ2, φ3, φ0, respectively, making up the four-phase clock signals, so that the results of determination DOUT[0], DOUTX[0] to DOUT[3], DOUTX[3] are output sequentially.

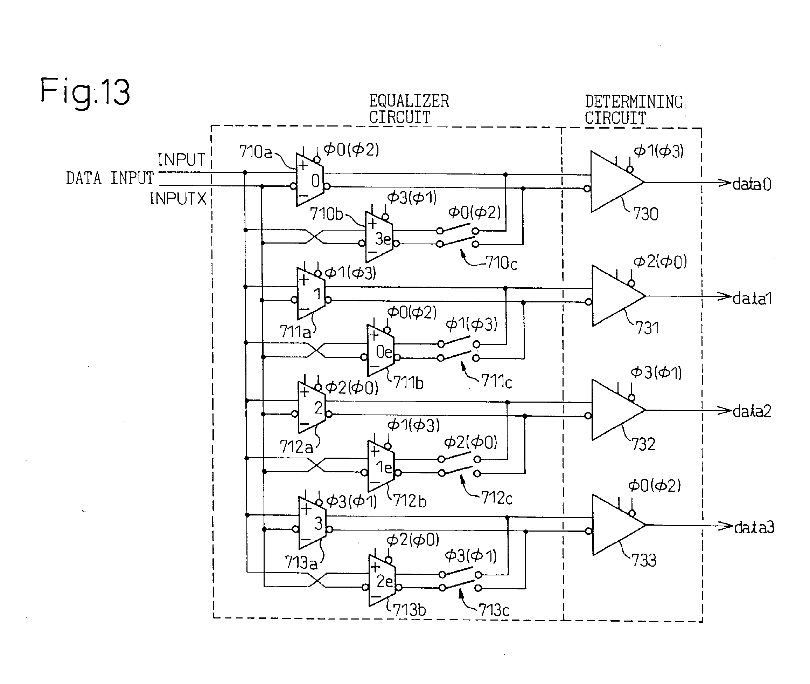

Fig. 13 is a block diagram showing a receiver circuit according to a fourth embodiment of the invention, and corresponds to a modification of the third embodiment described above. Specifically, according to the fourth embodiment, the determining circuit is configured as latches 730 to 733 for outputting a single-ended signal.

In Fig. 13, reference numerals 710a, 711a, 712a, 713a designate first amplifiers (corresponding to the differential amplifier 610a in Fig. 10), numerals 710b, 711b, 712b, 713b second differential amplifiers (corresponding to the differential amplifier 610b in Fig. 10), and numerals 710c, 711c, 712c, 713c switches (corresponding to the transistors 6151, 6152 in Fig. 10). Reference numerals 730 to 733 designate latches (corresponding to the determining circuit 630 in Fig. 11) for receiving a differential input signal and outputting a single-ended signal. Reference numerals φ0 to φ3 designate four-phase clock signals 90° out of phase with each other. The first differential amplifiers 710a, 711a, 712a, 713a and the second differential amplifiers 710b, 711b, 712b, 713b are configured as transconductors, and by turning on the switches 710c, 711c, 712c, 713c, the output currents of the transconductors are added to adjust the magnitude of the output (weight the output), thereby compensating for the inter-signal interference caused by the characteristics of the transmission path.

The first differential amplifiers 710a, 711a, 712a, 713a have the retrieval timing of data inputs (INPUT, INPUTX) thereof controlled by the clock signals φ0 (φ2), φ1 (φ3), φ2 (φ0), φ3 (φ1), respectively. Also, the second differential amplifiers 710b, 711b, 712b, 713b have the retrieval timing of data inputs thereof controlled by the clock signals φ3 (φ1), φ0 (φ2), φ1 (φ3), φ2 (φ0), respectively. The switches 710c, 711c, 712c, 713c have the switch timing thereof controlled by the clock signals φ0 (φ2), φ1 (φ3), φ2 (φ0), φ3 (φ1), respectively. Further, the latches 730, 731, 732, 733 have the retrieval timing of the input data thereof (output signals of the equalizer circuit) controlled by the clock signals φ1 (φ3), φ2 (φ0), φ3 (φ1), φ0 (φ2), respectively.

Specifically, assume that the sample switches (see the sample switches 6111, 6112 of the first differential amplifier 610a in Fig. 10) of the first differential amplifier 710a are turned off at the fall of the clock signal φ2 (at the rise of the clock signal φ0). At the same time, at the rise of the clock signal φ0, the current source switch (see the transistor 6107 of the first differential amplifier 610a in Fig. 10) in the first differential amplifier 710a turns on and the first differential amplifier (transconductor) 710a begins to be driven. In similar fashion, at the same time that the sample switch (see the sample switches 6141, 6142 of the first differential amplifier 610b in Fig. 10) of the second differential amplifier 710 is turned off at the fall of the clock signal φ1 (the rise of the clock signal φ3), for example, the current source switch (see the transistor 6137 of the second differential amplifier 610b in Fig. 10) of the second differential amplifier 710b is turned on at the rise of the clock signal φ3, so that the second differential amplifier (transconductor) 710b begins to be driven.

Then, at the same time that the sample switches (6111, 6112) of the first differential amplifier 710a are connected at the rise of the clock signal φ2, the clock signal φ0 falls and the current source switch (6107) turns off. As a result, the first differential amplifier 710a turns off and only a very small current flows. Thus, the input to the sample switches is held at a constant level. Further, in the case where the switch 710c (see the transistors 6151, 6152 in Fig. 10) is turned on at the rise of the clock signal φ2, for example, the output (differential output) of the second differential amplifier 710b is connected with the output of the first differential amplifier 710a thereby to add to the output current. By thus adding the output currents of the two differential amplifiers (transconductors) 710a, 710b to each other, the output magnitude is adjusted (the current flowing in the current source 6140 of the differential amplifier 610b in Fig. 10 is controlled, for example). In this way, the inter-signal interference caused by the characteristics of the transmission path is compensated for.

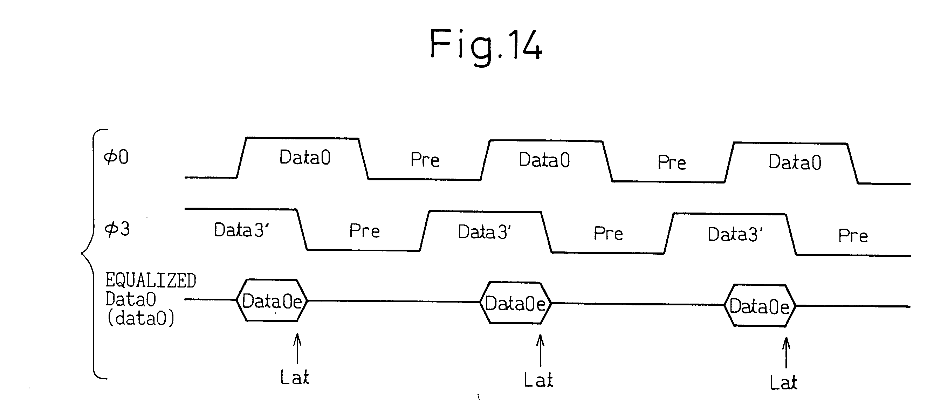

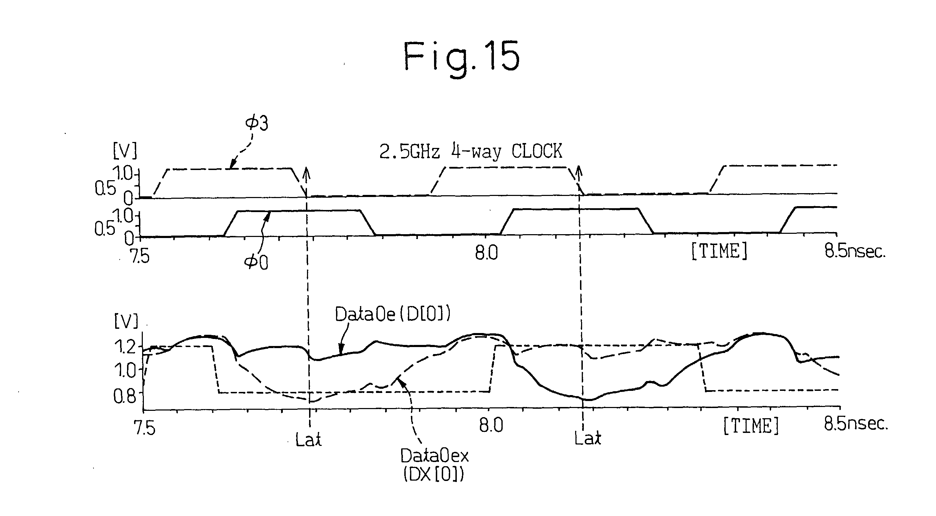

Fig. 14 is a diagram for explaining the operation of the receiver circuit shown in Fig. 13. Fig. 15 is a diagram showing an example of waveforms for explaining the operation of the receiver circuit shown in Fig. 13. Specifically, Fig. 15 is a diagram for explaining the operation of the first differential amplifier 710a, the second differential amplifier 710b, the switch 710c and the latch 730 in Fig. 13. In Figs. 14 and 15, reference character Data0 designates the output data of the first differential amplifier 710a controlled by the clock signal φ0 (φ2), character Data3' the output data of the second differential amplifier 710b controlled by the clock signal φ3 (φ1), and character DataOe the output data (the output data Data0 of the equalizer circuit) after being equalized by the switch 710c controlled by the clock signal φ0 (φ2). Further, reference character Pre designates the precharge period for the first and second differential amplifiers, and character Lat designates the timing of retrieving (latching) the data (DataOe) through the latch 730 controlled by the clock signal φ1 (φ3). In Fig. 15, reference characters DataOe, DataOex designate the differential outputs after equalization.

As shown in Figs. 14 and 15, the latch timing Lat of the latch (determining circuit) 730 is the fall of the clock signal φ3 (the rise of the clock signal φ1), and the precharge Pre is performed when the clock signal φ3 is at high level "H" (when the clock signal φ1 is at low level "L"). At each latch timing Lat of the latch 730, the differential outputs after equalization (differential outputs of the equalizer circuit) DataOe, DataOex are retrieved by the latch 730 for determination.

As apparent from Fig. 15, the differential outputs DataOe, DataOex of the equalizer circuit are both precharged (for example, with the high-potential source voltage VDD of about 1.3 volts) during the precharge period Pre and then assume a voltage level corresponding to the data inputs (INPUT, INPUTX). The latch 730, on the other hand, performs the latch operation at the timing Lat when a sufficient differential voltage is generated in the differential outputs DataOe, DataOex of the equalizer circuit, thus making accurate data determination possible.

The foregoing description refers to four sets of the equalizer circuits 610 to 613 and the determining circuits 630 to 633 controlled by the four-phase clock signals φ0 to φ3. Nevertheless, the clock signals and the equalizer circuits (buffer circuits) can be variously modified. Also, apart from the foregoing description that the equalizer 610 is configured of two differential amplifiers 610a, 610b, this configuration can of course also be variously modified.

The receiver circuit according to the second aspect of the invention will be explained in detail below with reference to the drawings.

In the case where the signal transmission rate reaches a very high value (frequency) of several Gbps, the frequency of the received signal may exceed that of the LSI and therefore, a receiver circuit capable of high-speed operation is required for receiving the signal. Generally, the receiver circuit including a bipolar element such as a CMOS transistor or a low-speed element as compared with the high-speed transistor made of such a material as GaAs or SiGe, as described above, is configured of a switch (sampling circuit) and a buffer circuit connected in series with the input line. The value of the signal at the timing when the switch turns off is sampled and constitutes the output of the buffer, the output of which is latched thereby to determine the signal value.

The receiver according to the second aspect of the invention described below has no switch at the input thereof but uses a differential pair (differential transistor pair) as a sampling circuit. Also in the receiver circuit according to this second aspect of the invention, as in the receiver circuit according to the first aspect of the invention described above, there is provided a circuit for determining data accurately by removing the effect of the inter symbol interference due to the variations of the voltage corresponding to the signal value before the determination and preventing the past signal value from adversely affecting the determining circuit.

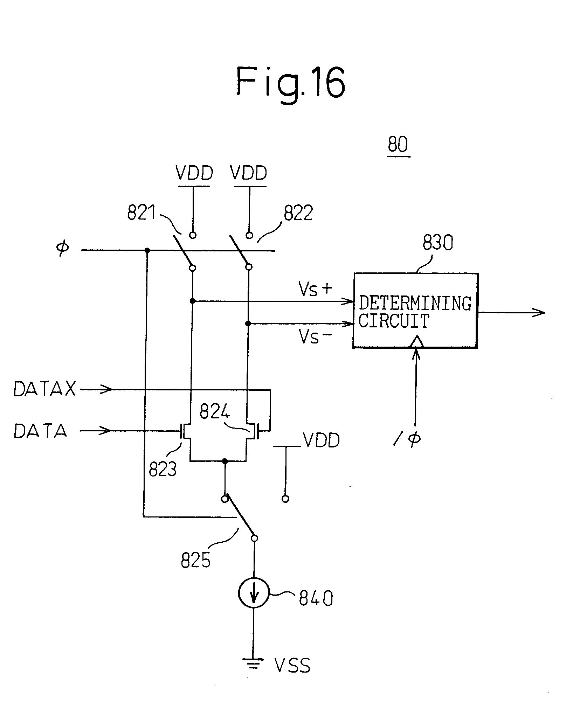

Fig. 16 is a block diagram showing an example of a basic configuration of the receiver circuit according to the second aspect of the invention, and shows a configurational example of the receiver circuit (receiver unit). A receiver circuit is configured of two receiver units 80 of the type shown in Fig. 16 which perform the operation by interleaving. The receiver circuit according to the second aspect of the invention is not limited to the configuration including two receiver units but may alternatively include a plurality of, say, 4 or 8 receiver units.

As shown in Fig. 16, the receiver circuit (receiver unit) 80 is configured of switches 821, 822, 825, a differential transistor pair (nMOS transistors) 823, 824, a determining circuit 830 and a current source 840.

The switches 821, 822, 825 are controlled by the clock signal φ. The switches 821 and 822, for example, turn off when the clock signal φ is at high level "H", while the switch 825 connects the current source 840 to the differential transistor pair 823, 824 when the clock signal φ is at high level "H", for example. The differential transistor pair 823, 824 make up a sampling circuit, and the source current (tail current) of the differential transistor pair 823, 824 is supplied by the current source 840 for the pulse current output.

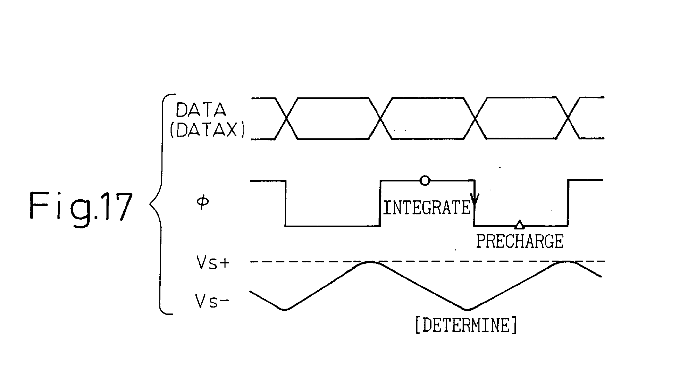

Fig. 17 is a diagram for explaining the operation of the receiver circuit shown in Fig. 16.

As shown in Figs. 16 and 17, the output of the differential transistor pair 823, 824 is connected with the switches (precharge transistors) 821, 822. During the period when the sampling circuit (differential transistor pair 823, 824) produces no output (when the clock signal φ is at low level "L"), the precharge transistors 821, 822 turn on, so that the outputs (Vs+, Vs-) are precharged to VDD. As soon as the sampling period is started (when the clock signal φ turns from low level "L" to high level "H"), the precharge transistors 821, 822 turn off. At the same time, the current source 840 turns on and supplies the tail current in pulse form.

During the period when the tail current flows, the transconductors produce an output current, and therefore, the inputs (DATA, DATAX) are integrated at the output nodes (Vs+, Vs-). When the pulse current turns off, the integration is completed. At the same time, the clock signal /φ turns from low level "L" to high level "H" (the clock signal φ turns from high level "H" to low level "L"), and the determining circuit 830 determines the outputs (Vs+, Vs-). After that (or as soon as the integration ends), the clock signal φ turns to high level "H", and the precharge transistors 821, 822 turn on. Thus, the output nodes (Vs+, Vs-) are precharged again to VDD.

As shown in Figs. 16 and 17, the determining circuit 830 in the subsequent stage determines the signal "0" or "1" at the end of the integration period when the output of the sampling circuit assumes a maximum value (the potential difference of the outputs Vs+, Vs- due to the differential transistor pair 823, 824 becomes maximum). The output of the sampling circuit is not dependent on the input during the time when the pulse current is off (when the switch 825 is off), and therefore it becomes possible to remove the inter symbol interference caused by the great variation in the voltage in the receiver. The circuit shown in Fig. 16 cannot receive the signal during the precharge period of the sampling circuit, and therefore for receiving the continuous data, at least two of the circuits are required to be used alternately (by interleaving).

With the receiver circuit according to the second aspect of the invention, the effect of the signals DATA, DATAX received before the bit cells to be determined is not input to the determining circuit 830, and therefore the inter symbol interference of a series of the received signals generated by excessive voltage variations in the receiver can be reduced. As a result, the input signal can be determined with a higher accuracy.

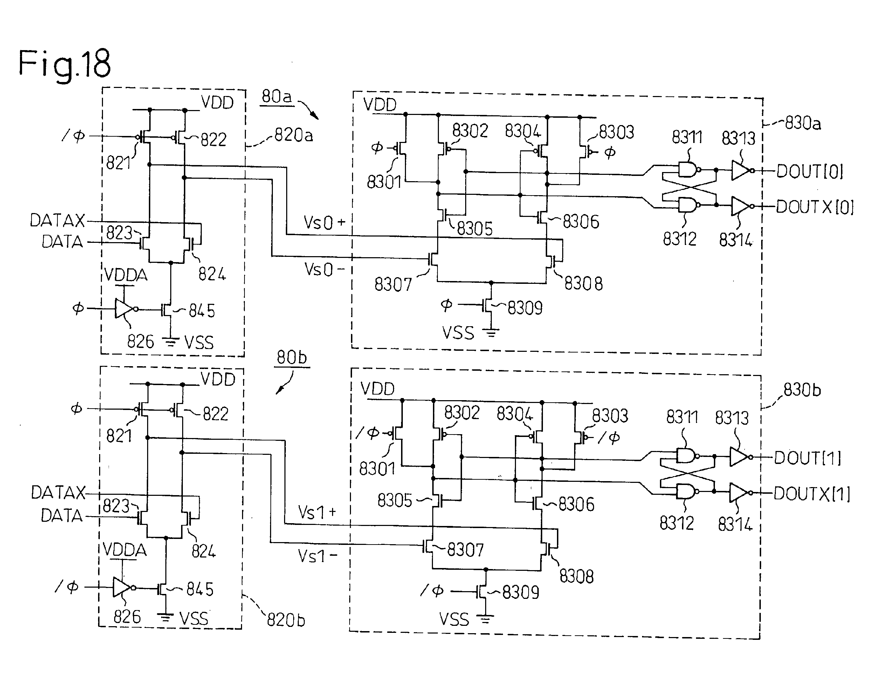

Fig. 18 is a circuit diagram showing a receiver circuit according to a fifth embodiment of the invention, and shows an example in which two receiver units 80a, 80b are driven by interleaving the clock signals φ, /φ 180° out of phase with each other. The receiver circuit shown in Fig. 18 is for receiving the high-speed signal of 10 Gbps, for example, and is configured as a determining circuit operating two ways by the two-phase clock signals (i.e. one-phase differential clock signal) φ, /φ of 5 GHz.

Comparison between Figs. 18 and 16 clearly shows that according to the fifth embodiment, the switches (precharge transistors) 821, 822 are each configured of a pMOS transistor, while the switch 825 and the current source 840 are configured of a single nMOS transistor (pulse current source for driving the tail current) 845. The gate of the transistor 845 is supplied with the analog source voltage VDDA and supplied with the output of the inverter 826 for inverting the clock /φ.

According to the fifth embodiment, a receiver circuit is configured of a combination of sampling circuits (differential transistor pair 823, 824), output precharge circuits (transistors 821, 822), a pulse current source for driving the tail current (transistor 845) and a determining circuit (830a; 830b). The tail current drive pulse current source 845 is realized by driving the gate voltage of the transistor (the tail current drive pulse current source) 845 thereof with the output from the inverter 826 supplied with the 5-GHz clock signal φ (/φ) and the analog source voltage VDDA. The differential transistor pair 823, 824, the precharge transistors 821, 822 and the tail current drive pulse current source 845 make up each of the sampling units 820a, 820b.

Comparison between Figs. 18 and 11 clearly shows that the determining circuits 830a, 830b of the receiver units 80a, 80b in the receiver circuit according to the fifth embodiment have a similar configuration to the determining circuit 630 shown in Fig. 11. Specifically, the pMOS transistors 8301 to 8304, the nMOS transistors 8305 to 8309, the NAND gates 8311, 8312 and the inverters 8313, 8314 in the determining circuits 830a, 830b shown in Fig. 18 correspond to the pMOS transistors 6301 to 6304, the nMOS transistors 6305 to 6309, the NAND gates 6311, 6312 and the inverters 6313, 6314, respectively, of the determining circuit 630 shown in Fig. 11. Also, the clock signal φ (/φ) and the input signals Vs0+, Vs0-(Vs1+, Vs1-) in the determining circuit 830a (830b) shown in Fig. 18 correspond to the clock signal φ1 and the input signals D[0], DX[0], respectively, of the determining circuit 630 shown in Fig. 11.

The input signals Vs0+, Vs0- (Vs1+, Vs1-) of the determining circuit 830a (830b) are supplied from the sampling unit 820a (820b). The determining circuit 830a (830b) determines "0" or "1" of the signal at the rise of the clock signal φ (/φ). According to this fifth embodiment, only during the period (100 psec.) when the 5-GHz clock signal φ (/φ) is at high level "H", the sampling circuit integrates the input, and therefore the effect of the other bit cells on the output of the sampling circuit can be avoided.

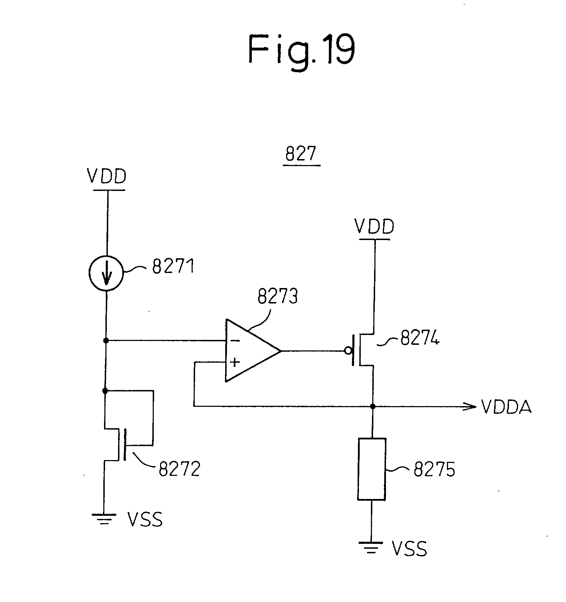

Fig. 19 is a diagram showing an example of the circuit 827 for generating the analog source voltage VDDA in the receiver circuit shown in Fig. 18.

The analog source voltage generating circuit 827 is configured of a current source 8271, a nMOS transistor 8272, a differential amplifier 8273, a pMOS transistor 8274 and a load 8275. The inverter 826 has as its source voltage the analog source voltage VDDA generated in this way, and by inverting the input clock φ (/φ), drives the tail current drive pulse current source (transistor 845).

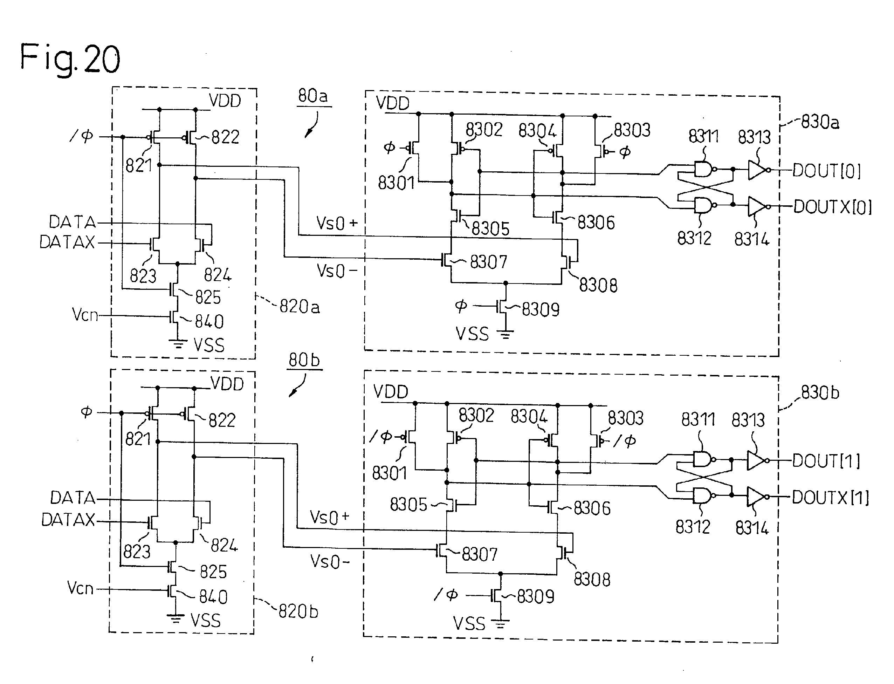

Fig. 20 is a circuit diagram showing a receiver circuit according to a sixth embodiment of the invention.

Comparison between Figs. 20 and 18 apparently shows that the receiver circuit according to the sixth embodiment includes a switch (switching transistor) 825 and a current source (tail current supply transistor) 840 connected in series to each other, as in the configuration including the tail current drive pulse current source (transistor) 845 of the receiver circuit in the fifth embodiment explained with reference to Fig. 16. The gate of the transistor 825 of the receiver unit 80a is supplied with the clock /φ, while the gate of the transistor 825 of other receiver unit 80b is supplied with the clock signal φ. The gate of the transistor 840 of each of the receiver units 80a, 80b is supplied with a constant gate voltage Vcn.

The receiver circuit according to the sixth embodiment does not include the inverter 826 driven by the analog source voltage VDDA and therefore has the advantage that the waveform for driving the gate can produce a speed equivalent to the normal logic.

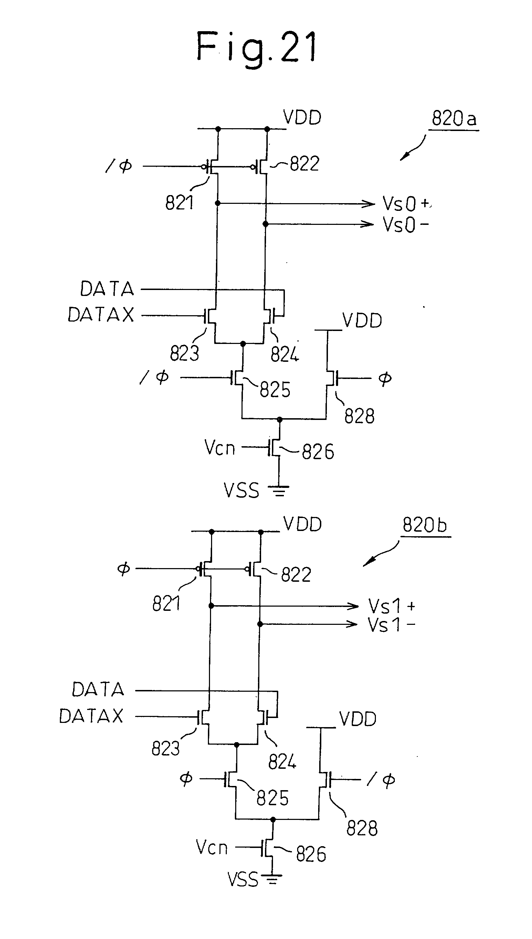

Fig 21 is a circuit diagram showing a receiver circuit according to a seventh embodiment of the invention, in which only the sampling units 820a, 820b of the receiver units 80a, 80b are shown.

Comparison between the sampling units of Figs. 21 and 20 makes apparent that in the receiver circuit (sampling units 820a, 820b) according to the seventh embodiment, the tail current is switched by another differential transistor pair 825, 828 supplied with the differential (complementary) clock signals φ, /φ. During the period when the sampling units (sampling circuit) are out of operation, the current from the tail current source 826 is applied through a bypass to the high-potential power supply VDD.

Specifically, in the case where the clock signal /φ turns to low level "L" and the transistor 825 turns off so that the transistor 826 for supplying the tail current is cut off from the differential transistor pair 823, 824 in the sampling unit 820a, the clock signal φ turns to high level "H" and the transistor 828 turns on, so that the transistor 826 for supplying the tail current is connected to the high-potential power line (VDD). In the case where the clock signal φ turns to low level "L" and the transistor 825 turns off so that the transistor 826 for supplying the tail current is cut off from the differential transistor pair 823, 824 in the other sampling unit 820b, on the other hand, the clock signal /φ turns to high level "H" and the transistor 828 turns on, so that the transistor 826 for supplying the tail current is connected to the high-potential power line (VDD).

As described above, the receiver circuit according to this seventh embodiment so operates that an always constant current is supplied from the tail current supply transistor 828, and therefore has the advantage that the variation of the drain voltage of the transistor 828 is reduced and the current can be switched at high speed.

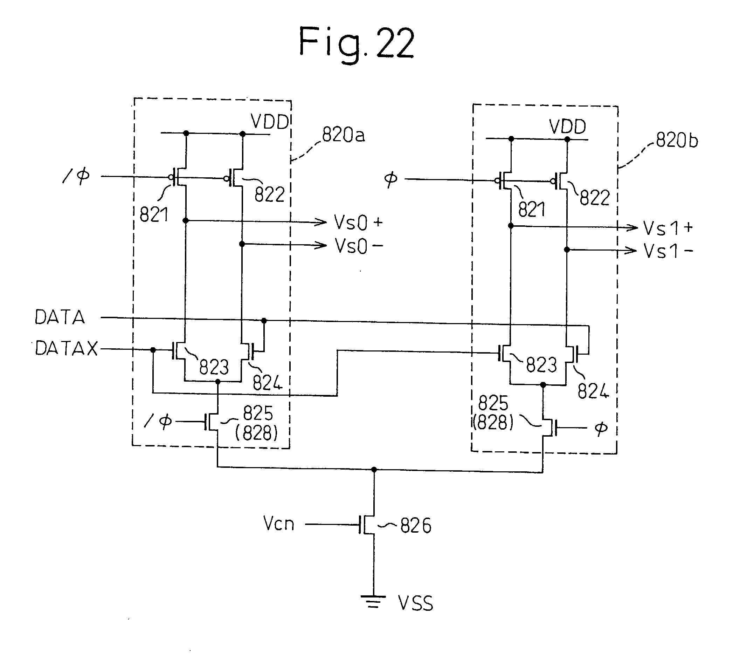

Fig. 22 is a circuit diagram showing a receiver circuit according to an eighth embodiment of the invention.

Comparison between Figs. 22 and 21 makes clear that the receiver circuit (sampling units 820a, 820b) according to the eighth embodiment is such that the transistor 828 which turns on and connects the tail current supply transistor 826 to the high-potential power line (VDD) when the transistor 825 of the receiver unit 820a turns off is used as a transistor 825 in the other receiver unit 820b, and the transistor 828 in the receiver unit 820b is used as the transistor 825 in the receiver unit 820a.

The receiver circuit according to the eighth embodiment has the advantage that the current can be switched at high speed by reducing the drain voltage variation of the tail current supply transistor 828 like in the seventh embodiment described above, and further the current consumption can be substantially reduced to one half since the tail current is not wastefully applied through a bypass to the power line VDD.

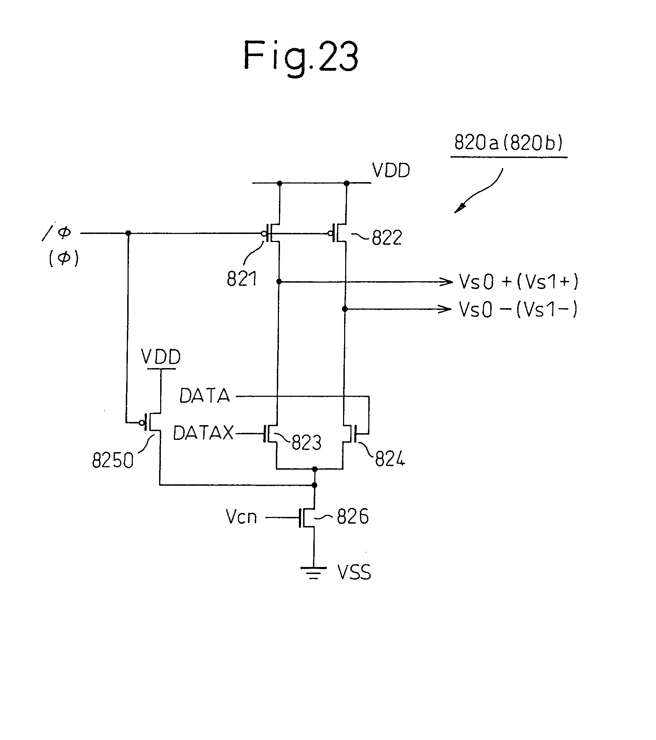

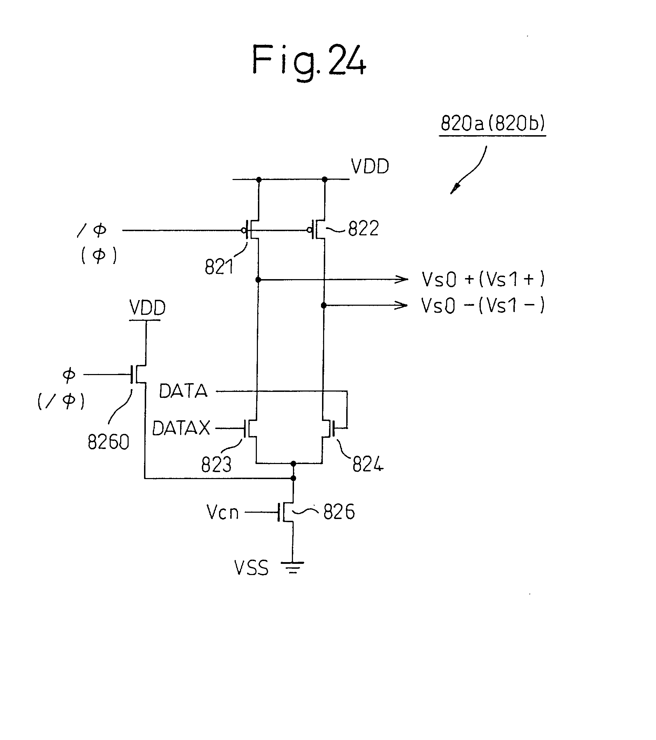

Fig. 23 is a circuit diagram showing a receiver circuit according to a ninth embodiment of the invention. Fig. 24 is a circuit diagram showing a modification of the receiver circuit of Fig. 23. Only the sampling unit 820a (820b) of one of the receiver units is shown in Figs. 23 and 24.

As shown in Fig. 23, in the receiver circuit (sampling unit 820a (820b)) according to the ninth embodiment, the tail current (the sum of the source currents of the differential transistor pair 823, 824) of the sampling circuit is switched by means of injecting the current from the high-potential power line (VDD) to the source nodes of the differential transistor pair 823, 824 using the transistor 8250.

Specifically, according to the ninth embodiment, the pMOS transistor 8250 is interposed between the high-potential power line (VDD) and the sources of the differential transistor pair 823, 824. When the gate voltage of the pMOS transistor 8250 is at low level "L", the source potentials of the differential transistor pair 823, 824 are pulled up to the high-potential source voltage VDD, with the result that the input differential transistor pair 823, 824 of the sampling unit 820a (820b) turn off. At the same time, all the current of the nMOS transistor 826 of the tail current source flows into the pMOS transistor. Further, when the gate voltage of the pMOS transistor 8250 turns to high level "H", the current ceases to be injected from the pMOS transistor 8250, so that all the current of the tail current source (826) flows as a tail current of the differential transistor pair 823, 824 of the sampling units.

As described above, according to the ninth embodiment, the tail current of the differential transistor pair 823, 824 of the sampling units is switched substantially by a switch (8250) connected in parallel but not in series to the tail current source 826, and therefore the operation with a still lower voltage is made possible without inserting a transistor in series to the tail current source 826.

Fig. 24 shows a modification of the receiver circuit according to the ninth embodiment described above. In this modification, an nMOS transistor 8260 is used in place of the pMOS transistor 8250 to change the source potential of the differential transistor pair 823, 824. The transistor 8260 is what is called source coupled, so that when the gate of the switching transistor is turned to high level "H", the source potential rises which in turn reduces the sum (tail current) of the source currents of the differential transistor pair 823, 824. In other words, the current of the tail current source 826 branches to the switching nMOS transistor 8260. By appropriately selecting the size of the switching nMOS transistor 8260, substantially all the current of the sampling units (differential transistor pair 823, 824) can be turned on/off. This modification can use a high-speed nMOS transistor and therefore has the advantage that the operating frequency of the circuit can be readily increased.

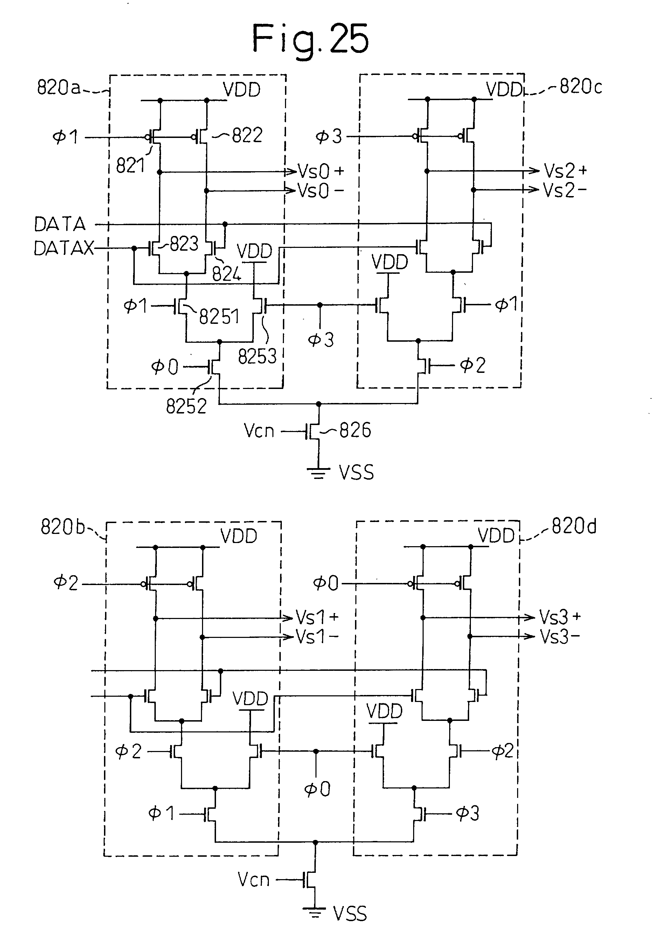

Fig. 25 is a circuit diagram showing a receiver circuit according to a tenth embodiment of the invention. In this embodiment, four-way operation is performed using the four-phase clock signals φ0 to φ3. The four-phase clock signals φ0 to φ3 are 90° out of phase with each other, for example, as shown in Fig. 12. Each of the sampling units 820a to 820d has a similar configuration. The sampling units 820a and 820c share a single tail current source (transistor) 826, while the sampling units 820b and 820d share a single tail current source 826.

The receiver circuit (sampling units) according to the tenth embodiment has such a circuit configuration that differential transistor pairs are stacked in two stages (8251, 8253 and 8252) and the sampling circuit is activated (integrating operation) by using the superposed portions of the four-phase clock signals φ0 to φ3. In the tenth embodiment involving the four-way operation, as compared with the two-way operation, the operation of the sampling circuit and the determining circuit can be doubled during a predetermined time, the signal frequency being the same, thereby leading to the advantage that the operating speed has a margin.

Specifically, the receiver circuit according to the tenth embodiment substantially includes two of the circuit shown in Fig. 22 to perform the four-way operation in accordance with the four-phase clock signals φ0 to φ3, using the transistors 8251 to 8253 as a switching transistor 825. This is by reason of the fact that among the transistors 8251 to 8253 turned on in response to the high level "H" of the clock signal supplied to the gates thereof, the transistor 8251 is required to be turned on after turning on the transistor 8252. More specifically, if the transistor 8252 is turned on after turning on the transistor 8251, the source current of the differential transistor pair 823, 824 cannot be supplied at high speed to the nMOS transistor 826 of the tail current source. In the case where the timing is such that the transistor 8252 is turned on after turning on the transistor 8251 as in the seventh embodiment shown in Fig. 21, therefore, the transistor 826 for supplying the tail current is connected to the high-potential power line (VDD).

As described later, these switching transistors (8251 to 8253) can alternatively be configured in a single stage depending on the clock signal used.

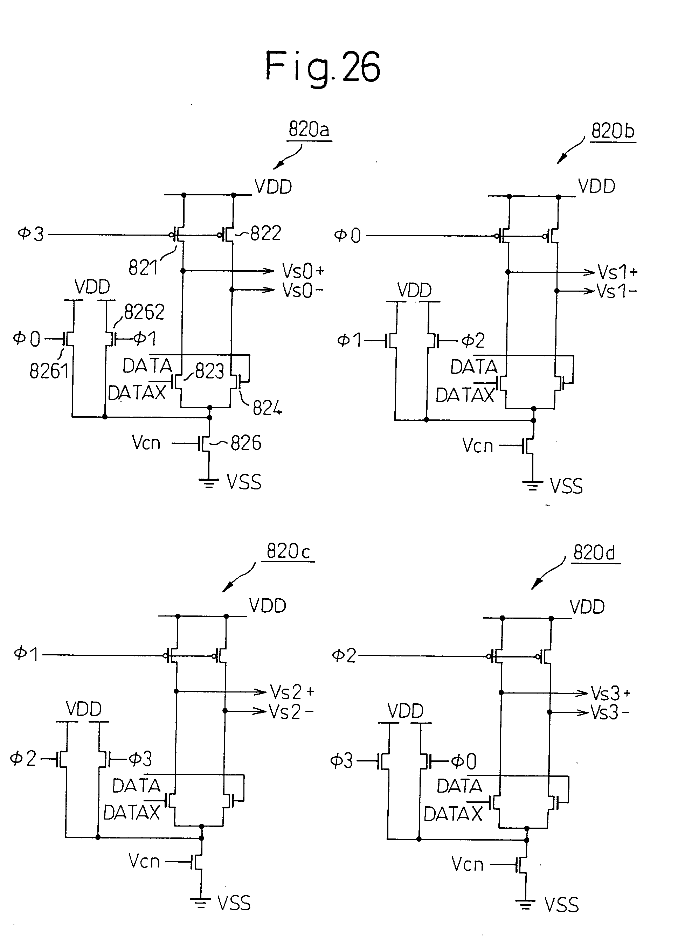

Fig. 26 is a circuit diagram showing a receiver circuit according to an 11th embodiment of the invention. In this embodiment, as in the tenth embodiment described above, four-way operation is performed using the four-phase clock signals φ0 to φ3. The sampling units 820a to 820d have a similar configuration.

Comparison between Figs. 26 and 24 makes clear that according to the 11th embodiment, the nMOS transistor (switch) 8260 in the modification of the ninth embodiment shown in Fig. 24 is replaced with two nMOS transistors 8261, 8262 supplied with two different clock signals, respectively.

As a specific example, in the sampling unit 820a, the gate of the transistor 8261 is supplied with the clock signal φ0 while the gate of the transistor 8262 is supplied with the clock signal φ1, and the sampling circuit is activated (integrating operation) only when both the clock signals φ0 and φ1 are at low level "L". In the other sampling units 820b to 820d, the sampling circuits are activated sequentially 90° out of phase with each other. As obvious from the relation between Figs. 24 and 23, two pMOS transistors can of course be used instead of the two nMOS transistors 8261, 8262.

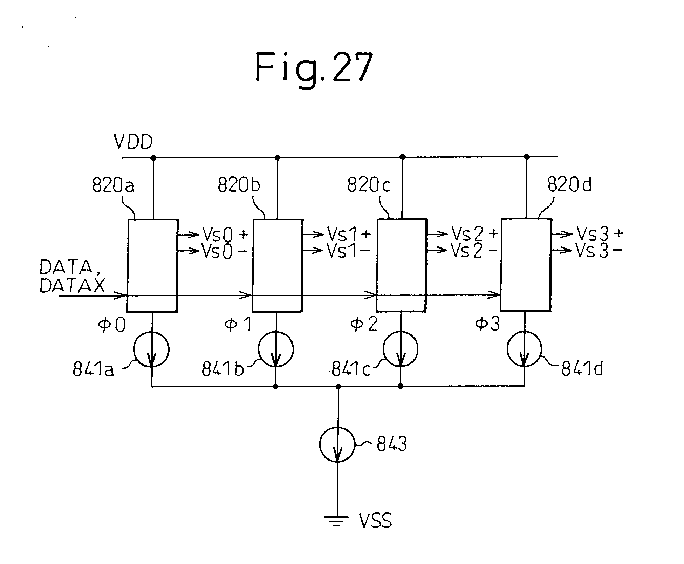

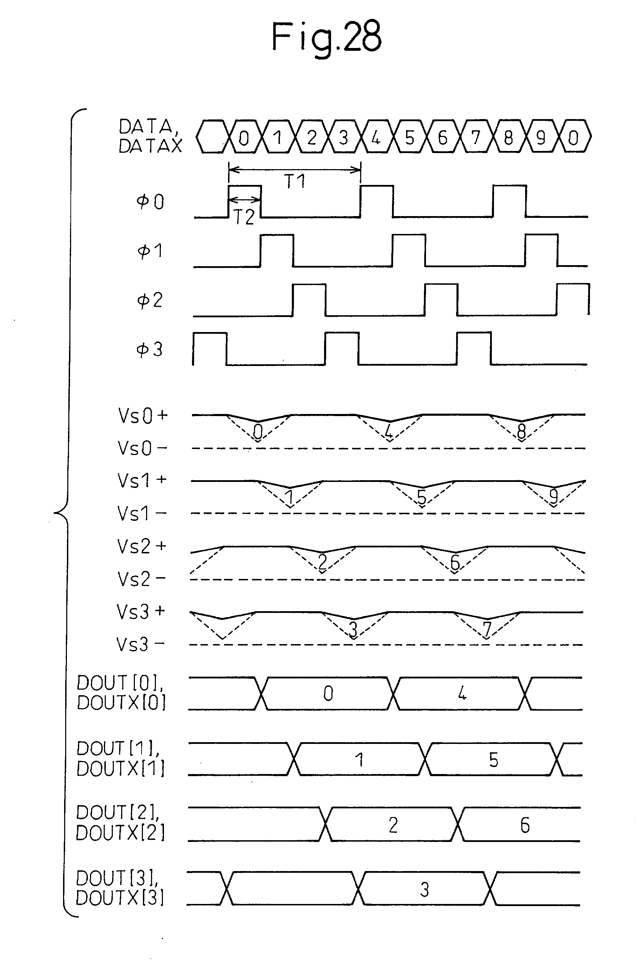

Fig. 27 is a block diagram showing a receiver circuit according to a 12th embodiment of the invention, and Fig. 28 is a timing chart for explaining the operation of the receiver circuit shown in Fig. 27. In the receiver circuit according to the 12th embodiment, four-way operation is performed using the four-phase clock signals φ0 to φ3 as shown in Fig. 28.
Specifically, the clock signals φ0 to φ3 are such four-phase clock signals 90° out of phase with each other that the time length T2 of high level "H" is one fourth of one period T1 (25 % in duty factor). The current sources 841a, 841b, 841c, 841d operate only during the period when the clock signals φ0, φ1, φ2, φ3, respectively, are at high level "H", and only during this operation period, the corresponding sampling units 820a, 820b, 820c, 820d are activated to perform the integrating operation.

As shown in Fig. 27, by controlling the current sources 841a to 841d using the four-phase clock signals φ0 to φ3 having a duty factor of 25 %, the sampling units 820a to 820d can be driven in four ways. In Fig. 28, characters DOUT[0], DOUTX[0]; DOUT[1], DOUTX[1]; DOUT[2], DOUTX[2]; DOUT[3], DOUTX[3] designate the outputs (determination results) of the determining circuits (830a, 830b, 830c, 830d) performing the four-way operation. These determining circuits 830a to 830d have a similar configuration to the determining circuit 830a shown in Fig. 18 and are sequentially supplied with four-phase clock signals φ0 to φ3 having different phases as control signals, respectively.

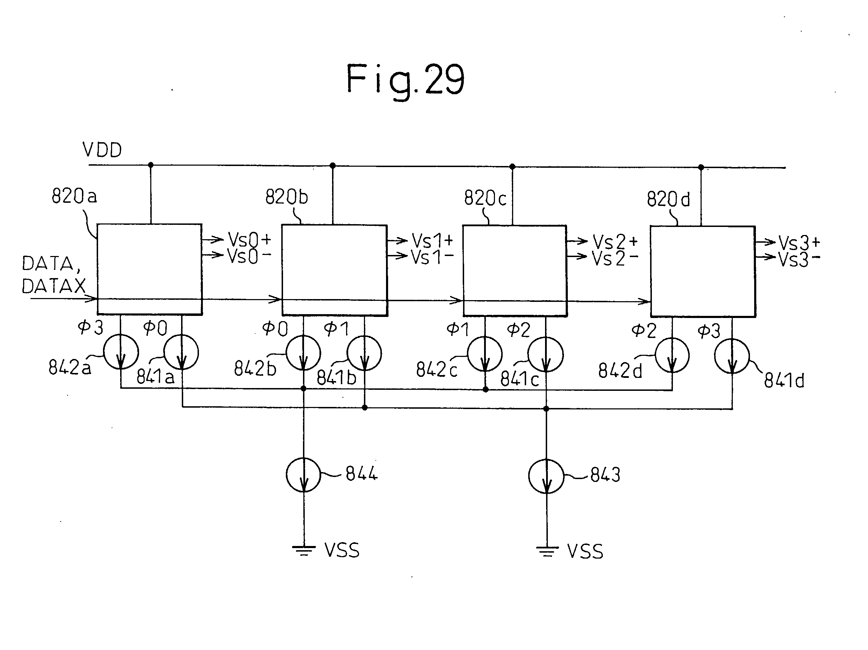

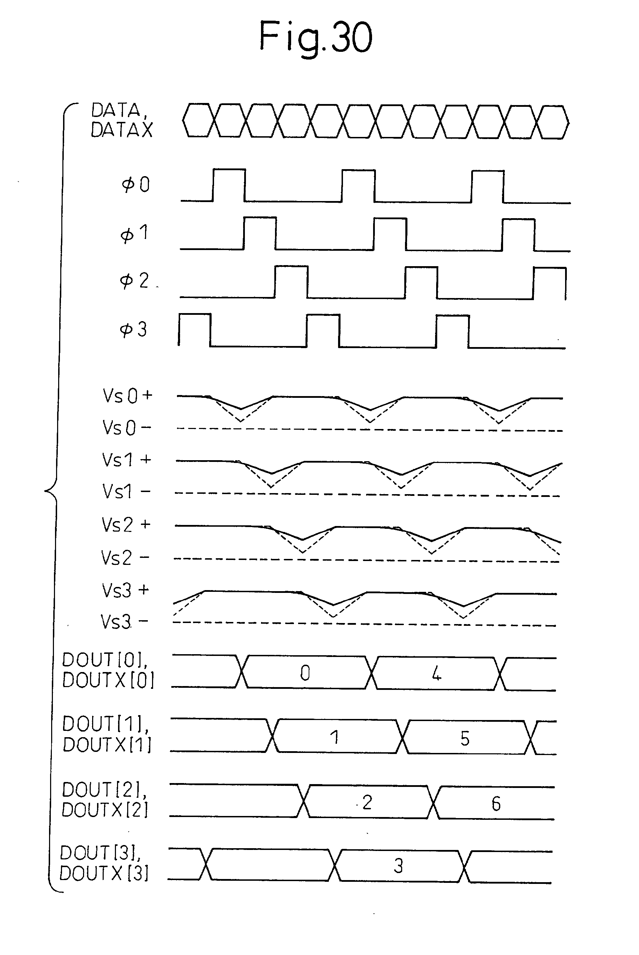

Fig. 29 is a block diagram showing a receiver circuit according to a 13th embodiment of the invention, and Fig. 30 a timing chart for explaining the operation of the receiver circuit shown in Fig. 29. The receiver circuit according to the 13th embodiment shown in Fig. 29, like the receiver circuit according to the fourth embodiment described with reference to Fig. 13, for example, is configured of an equalizer circuit having two differential amplifiers in place of the sampling units 820a to 820d of the 12th embodiment. The first differential amplifier, the second differential amplifier and the switch for controlling the connection of the first and second differential amplifiers are similar to the corresponding component parts of the fourth embodiment described above. Also, the output currents of the transconductors are added to adjust the magnitude of the output (weight the output) thereby to compensate for the inter-signal interference caused by the characteristics of the transmission path.

As shown in Figs. 29 and 30, the receiver circuit according to the 13th embodiment also carries out four-way operation using the four-phase clock signals φ0 to φ3 having a duty factor of 25 %.

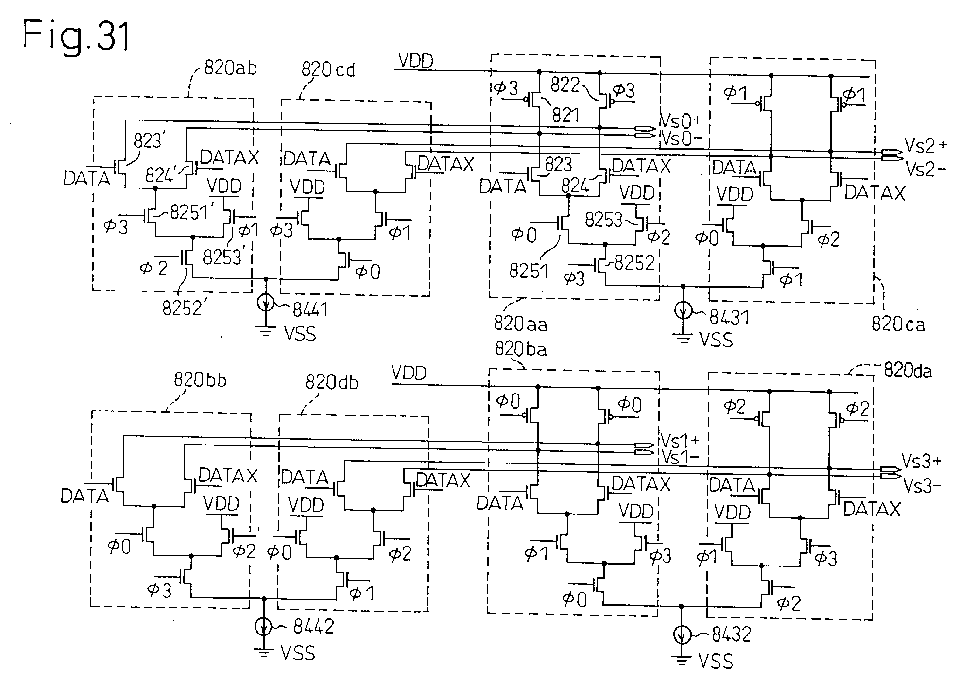

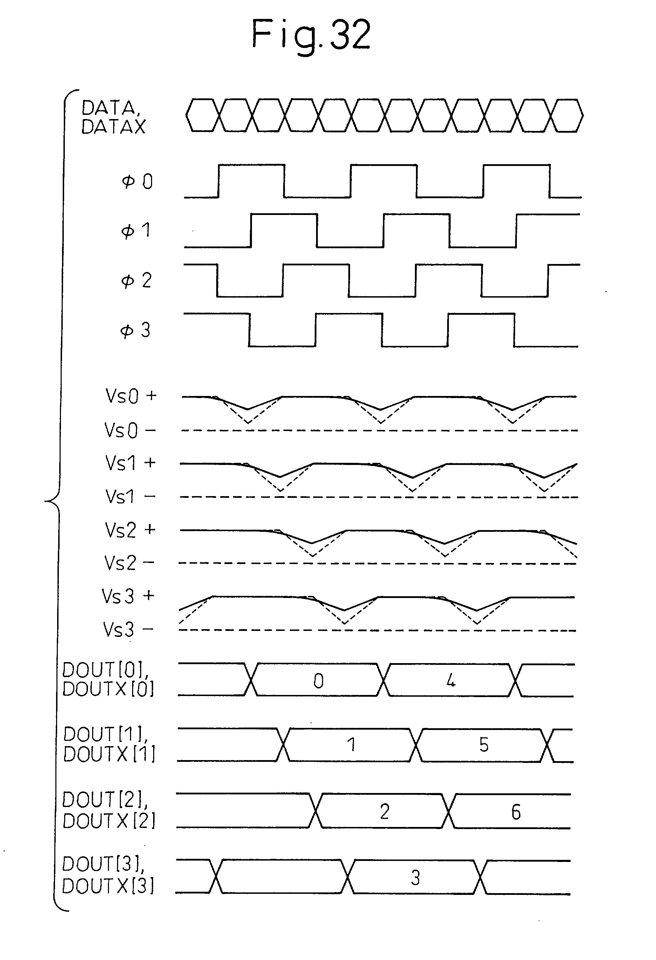

Fig. 31 is a circuit diagram showing a receiver circuit according to a 14th embodiment of the invention, and Fig. 32 a timing chart for explaining the operation of the receiver circuit shown in Fig. 31. The receiver circuit according to the 14th embodiment, like the receiver circuit according to the 13th embodiment, is configured of an equalizer circuit having two differential amplifiers 820aa, 820ab to 820da, 820db, respectively as the sampling units 820a to 820d.

Current sources 8431 and 8432 in the 14th embodiment correspond to the current source 843 in the 13th embodiment, while the current sources 8441 and 8442 in the 14th embodiment correspond to the current source 844 in the 13th embodiment shown in Fig. 29. Further, the circuits 820aa and 820ca making up a part of the sampling unit (the differential amplifier of one of the sampling units 820a and 820c) in the 14th embodiment correspond to the sampling units 820a and 820c according to the tenth embodiment shown in Fig. 25. Also, the circuits 820ba and 820da making up a part of the sampling unit (the differential amplifier of one of the sampling units 820b and 820d) in the 14th embodiment correspond to the sampling units 820b and 820d according to the tenth embodiment shown in Fig. 25. The circuit of Fig. 31 and the circuit of Fig. 25 are substantially similar to each other except for the difference in the node for retrieving the output (the output of the sampling unit) and the supply point of the control signals (clock signals φ0 to φ3).

Further, the receiver circuit according to the 14th embodiment includes second (the other set of) differential amplifiers 820ab, 820bb, 820cb, 820db in addition to the first (one set of) differential amplifiers 820aa, 820ba, 820ca, 820da. The second differential amplifiers 820ab, 820bb, 820cb, 820db are all configured similarly and have a differential transistor (nMOS transistor) pair 823', 824' and switches (transistors) 8251' to 8253' corresponding to the first differential amplifiers 820aa, 820ba, 820ca, 820da, respectively.

As shown in Figs. 31 and 32, the receiver circuit according to the 14th embodiment performs four-way operation using the four-phase clock signals φ0 to φ3 having a duty factor of 50 %.

Specifically, in the sampling unit 820a (the first differential amplifier 820aa and the second differential amplifier 820ab), for example, the switches (transistors) 8251, 8252 turn on and the differential transistor pair 823, 824 of the first differential amplifier 820aa sample the input signals (DATA, DATAX) only during the period when the clock signals φ0 and φ3 both are at high level "H", while the transistors 8251', 8252' turn on and the differential amplifier pair 823', 824' of the second differential amplifier 820ab perform the sample operation only during the period when the clock signals φ3 and φ2 both are at high level "H". Specifically, the differential transistor pair (sampling circuit) 823', 824' sample the bit following the bit sampled by the differential transistor pair 823, 824, and a signal representing the sum of the particular bits is produced as an output Vs0+, Vs0- and determined by the determining circuit. In this way, according to the 14th embodiment, the two differential amplifiers (820aa, 820ab; 820ba, 820bb; 820ca, 820cb; 820da, 820db) adjust the output level and compensate for the characteristics of the signal transmission path (reduce the inter symbol interference).

The output levels of the first differential amplifiers 820aa, 820ba, 820ca, 820da, for example, can be adjusted by controlling the current flowing in the current sources 8431, 8432. The output level of the second differential amplifiers 820ab, 820bb, 820cb, 820db can be adjusted also by controlling the current flowing in the current sources 8441, 8442. Normally, however, it is sufficient to adjust the output level of the first differential amplifiers by controlling the current flowing in the current sources 8431, 8432.

It will thus be understood from the foregoing description, in the receiver circuit according to this invention, the inter symbol interference caused by the characteristics of the transmission path which poses a problem for receiving the high-speed signal can be invalidated, and therefore the high-speed received signal can be determined with a higher accuracy than in the prior art.

As described above in detail, according to this invention, there is provided a receiver circuit in which the inter symbol interference can be removed and data can be determined with higher accuracy.

Many different embodiments of the present invention may be constructed without departing from the scope of the present invention, and it should be understood that the present invention is not limited to the specific embodiments described in this specification, except as defined in the appended claims.

## Claims

1. A receiver circuit comprising:
a sampling circuit for sampling an input signal;
a buffer circuit for buffering an output of said sampling circuit;
a determining circuit for determining an output of said buffer circuit; and
a buffer control circuit for restricting an input signal dependency of the output of said buffer circuit until said sampling is carried out.

2. A receiver circuit comprising:
a sampling circuit for sampling an input signal;
a buffer circuit for buffering an output of said sampling circuit;
a determining circuit for determining an output of said buffer circuit; and
a buffer control circuit for keeping a substantially constant value of the output of said buffer circuit until said sampling is carried out.

3. The receiver circuit as claimed in claim 1 or 2, wherein said buffer control circuit is a switch arranged between said buffer circuit and a power line.

4. The receiver circuit as claimed in claim 1 or 2, wherein said buffer control circuit is a switch arranged between the output of said buffer circuit and a load device.

5. The receiver circuit as claimed in any preceding claim, further comprising a precharge circuit for precharging an input of said determining circuit before said sampling circuit samples the input signal.

6. The receiver circuit as claimed in any preceding claim, wherein said sampling circuit comprises a plurality of sample switches for sampling a series of bits, and a plurality of said buffer circuits corresponding in number to said sample switches are provided.

7. The receiver circuit as claimed in any preceding claim, wherein said buffer circuit comprises a plurality of buffer circuit units, and characteristics of a signal transmission path are compensated by adjusting a magnitude of an output of said buffer circuit units.

8. The receiver circuit as claimed in any preceding claim, wherein said buffer circuit is a transconductor for converting an input voltage to a current, and said buffer control circuit is a current source switch which keeps a current of said transconductor small until said sampling is carried out.

9. The receiver circuit as claimed in any of claims 1 to 7, wherein said buffer circuit comprises a micro current circuit for keeping a micro current flowing in said buffer circuit before said sampling circuit samples the input signal.

10. The receiver circuit as claimed in any preceding claim, further comprising a switching circuit for ensuring a substantially constant output of said buffer circuit when said sampling circuit samples the input signal, provided at the output of said buffer circuit.

11. A receiver circuit comprising:
a sampling circuit for sampling an input signal;
a determining circuit for determining an output of said sampling circuit; and
a sampling control circuit for dynamically changing a transconductance from the input to the output of said sampling circuit and reducing the input signal dependency of the output of said sampling circuit at times other than a sampling time point.

12. The receiver circuit as claimed in claim 11, wherein said sampling control circuit changes by switching the transconductance from the input to the output of said sampling circuit.

13. The receiver circuit as claimed in claim 12, wherein said transconductance is switched by switching a tail current of a differential transistor pair.

14. The receiver circuit as claimed in claim 13, wherein said tail current is switched by switching a current path between a route of said tail current of said transconductor and the other routes.

15. The receiver circuit as claimed in claim 14, wherein said current is switched by a transistor switch for switching the drain current of said differential transistor pair.

16. The receiver circuit as claimed in claim 14, wherein said current is switched by injecting to a source of the input transistor of said transconductor a current in such a direction as to turn off said input transistor.

17. The receiver circuit as claimed in claim 14, wherein said current is switched by use of a transistor connected in parallel such that the period during which said tail current flows is determined by the superposed portion of multi-phase clock signals.

18. The receiver circuit as claimed in claim 14, wherein said current is switched by use of a transistor connected in series such that the period during which said tail current flows is determined by the superposed portion of multi-phase clock signals.

19. The receiver circuit as claimed in any of claims 11 to 18, wherein a plurality of said sampling circuits sample different bit cells for a single determining circuit, and a weighted sum of the outputs of a plurality of said sampling circuits is determined.

20. A signal transmission system comprising a driver circuit, a signal transmission portion and a receiver circuit as claimed in any one of the preceding claims, for receiving an output of said driver circuit sent through said signal transmission portion.

21. A receiver circuit device comprising a plurality of receiver units operating in interleaved fashion, wherein each receiver unit is as claimed in any one of claims 1 to 19.
